# EUROPEAN PATENT APPLICATION

(11) **EP 4 842 165 A1**
(43) Date of publication of application: **18.11.2026**
(21) Application number: 26151394.9
(22) Date of filing: 12.01.2026
(51) Int. Cl.: H10F 19/90, H10F 19/80, H10F 77/20

(54) **SOLAR CELL AND PHOTOVOLTAIC MODULE**

(30) Priority: 12.05.2025 CN 202510608856
(71) Applicant: Jinko Solar (Haining) Co., Ltd., Haining City, Zhejiang (CN)
(72) Inventor: QIU, Lifeng, Haining City (CN); YANG, Jie, Haining City (CN); XIA, Zhipeng, Haining City (CN); HUANG, Jide, Haining City (CN); LIU, Changming, Haining City (CN); ZHANG, Xinyu, Haining City (CN); JIN, Hao, Haining City (CN)
(74) Representative: Balder IP Law, S.L.

(57) **Abstract**

The disclosed relates to the technical field of photovoltaics, and provides a solar cell and a photovoltaic module, which are at least beneficial to improving a transport efficiency of carriers in the solar cell. The solar cell includes a substrate, a side of the substrate being divided into two edge regions opposite to each other and a central region formed therebetween; multiple grid lines disposed on the substrate and positioned at intervals along a first direction; first solder joints and second solder joints disposed in the two edge regions and disposed at intervals along the first direction, where the first solder joints being positioned at intervals along a second direction, the second solder joints being positioned at intervals along the second direction and closer to the central region than the first solder joints, and an area of an orthographic projection of a respective first solder joint of the first solder joints on the substrate is smaller than an area of an orthographic projection of a respective second solder joint of the second solder joints on the substrate; and multiple solder joint connection lines disposed in the two edge regions.

## Description

### TECHNICAL FIELD

The various embodiments described in the present disclosure relate in general to the technical field of photovoltaics, and more specifically to a solar cell and a photovoltaic module.

### BACKGROUND

As fossil energy resources are gradually being depleted, solar cells have been widely used as a new energy alternative. A solar cell is an apparatus for converting solar energy into electrical energy. The solar cell generates carriers based on a photovoltaic principle, and the carriers are led out by grid lines, thereby enabling effective utilization of the electrical energy. The grid lines of solar cells play an important role in collecting and transmitting electrons. When a plurality of solar cells are assembled into a photovoltaic module, solder joints are usually formed on the grid lines, and solder strips are subsequently brought into electrical contact with the solder joints to electrically connect the grid lines of adjacent solar cells.

However, when establishing electrical contact between the solder strips and the solder joints, both solder paste applied to the solder strips and stress exerted by the solder strip have a significant impact on a single solar cell at starting and ending solder joints of soldering regions of the solder strips. This easily results in unstable electrical connections between the starting and ending solder joints and the grid lines in these regions, which are detrimental to efficient transport of carriers and may easily reduce the photovoltaic conversion efficiency of the solar cell. Therefore, a more suitable method needs to be identified to enhance the photovoltaic conversion efficiency of solar cells.

### SUMMARY

Embodiments of the present disclosure provide a solar cell and a photovoltaic module, which are at least beneficial to improving a transport efficiency of carriers in the solar cell.

One aspect of some embodiments of the present disclosure provide a solar cell, including a substrate, a side of the substrate being divided into two edge regions opposite to each other and a central region between the two edge regions; a plurality of grid lines disposed on the substrate and positioned at intervals along a first direction; first solder joints and second solder joints disposed in the two edge regions, where the first solder joints being positioned at intervals along a second direction perpendicular to the first direction, the second solder joints being positioned at intervals along the second direction and closer to the central region than the first solder joints, and an area of an orthographic projection of a respective first solder joint of the first solder joints on the substrate being smaller than an area of an orthographic projection of a respective second solder joint of the second solder joints on the substrate; and a plurality of solder joint connection lines disposed in the two edge regions. A respective solder joint connection line of the plurality of solder joint connection lines is connected to a corresponding first solder joint of the first solder joints, to a corresponding second solder joint of the second solder joints, and to grid lines of the plurality of grid lines disposed on a side of the correspondingsecond solder joint away from the central region.

In some embodiments, a number of grid lines of the plurality of grid lines connected with a respective first solder joint of the first solder joints is less than or equal to a number of grid lines of the plurality of grid lines connected with a respective second solder joint of the second solder joints. And/or the side of the substrate is further divided into a plurality of soldering regions positioned at intervals along the second direction and overlapped the two edge regions, and two corresponding second solder joints of the second solder joints, at least one corresponding first solder joint of the first solder joints, and at least one corresponding solder joint connection line of the plurality of solder joint connection lines are disposed in a respective soldering region of the plurality of soldering regions.

In some embodiments, the solar cell is a back contact solar cell. A side of the substrate is divided into a plurality of soldering regions positioned at intervals along the second direction and overlapped the two edge regions. The first solder joints are disposed alternately on both sides of the central region, and a respective first solder joint of the first solder joints is disposed in a corresponding soldering region of the plurality of soldering regions.

In some embodiments, the side of the substrate is divided into a plurality of soldering regions positioned at intervals along the second direction and overlapped the two edge regions. A respective first solder joint of the first solder joints is disposed in a corresponding soldering region of the plurality of soldering regions. And a number of first solder joints disposed on a first side of the central region is greater than a number of first solder joints disposed on an opposing second side of the central region.

In some embodiments, one respective soldering region of the plurality of soldering regions has a first solder joint disposed on the second side and in the respective soldering region further has a first solder joint disposed on the first side and in the respective soldering region.

In some embodiments, both a number of the first solder joints disposed on the second side and a number of the plurality of soldering regions are even numbers, and either the plurality of soldering regions or the first solder joints disposed on the second side are in axially symmetric arrangement about a central axis along the first direction.

In some embodiments, the solar cell further includes a plurality of columns of third solder joints disposed in the central region, wherein a respective third solder joint of the plurality of columns of third solder joints is connected to at least one corresponding grid line of the plurality of grid lines, and a respective column of the plurality of columns of third solder joints includes a plurality of third solder joints positioned at intervals along the first direction and is aligned with two corresponding second solder joints of the second solder joints. Along a thickness direction of the substrate, a thickness of the respective second solder joint is less than a thickness of the respective first solder joint and a thickness of the respective third solder joint, and/or the area of the orthographic projection of the respective first solder joint on the substrate is smaller than an area of an orthographic projection of a respective third solder joint of the plurality of columns of third solder joints on the substrate.

In some embodiments, in the first direction, a distance between the respective second solder joint and a corresponding third solder joint of the plurality of columns of third solder joints adjacent to the respective second solder joint is smaller than a distance between the respective second solder joint and a corresponding first solder joint of the first solder joints adjacent to the respective second solder joint.

In some embodiments, the solar cell is a back contact solar cell. A side of the substrate is further divided into alternating first soldering regions and second soldering regions disposed along the second direction. The plurality of grid lines include alternating first finger electrodes and second finger electrodes disposed along the first direction. A respective first finger electrode of the first finger electrodes that is disposed in either one of the two edge regions has disconnections in the second soldering regions, and a respective second finger electrode of the second finger electrodes that is disposed in either one of the two edge regions has disconnections in the first soldering region. The solar cell further includes a plurality of third solder joints disposed in the central region and positioned at intervals along the first direction and the second direction. A respective third solder joint of the plurality of third solder joints that is disposed in a corresponding first soldering region of the first soldering regions is connected to a corresponding first finger electrode of the first finger electrodes, and a respective third solder joint of the plurality of third solder joints that is disposed in a corresponding second soldering region of the second soldering regions is connected to a corresponding second finger electrode of the second finger electrodes.

In some embodiments, the solar cell further includes auxiliary lines. A respective auxiliary line of the auxiliary lines is connected a corresponding second solder joint of the second solder joints, and to at least one corresponding third solder joint of the plurality of third solder joints that is aligned with the corresponding second solder joint in the first direction.

In some embodiments, an area of a cross-section of the respective auxiliary line perpendicular to the first direction is smaller than an area of a cross-section of the respective solder joint connection line perpendicular to the first direction.

In some embodiments, the solar cell is a back contact solar cell. A side of the substrate is further divided into two periphery regions opposite to each other. Each periphery region of the two periphery regions extends along the first direction. The plurality of grid lines include alternating first finger electrodes and second finger electrodes disposed along the first direction. The solar cell further includes: connecting parts, and periphery connection lines at least partially disposed in the two periphery regions. A respective periphery connection line of the periphery connection lines is connected to corresponding first finger electrodes of the first finger electrodes or to corresponding second finger electrodes of the second finger electrodes. A respective connecting part of the connecting parts is configured to connect a corresponding periphery connection line of the periphery connection lines to a corresponding second solder joint of the second solder joints that is closest to a periphery region of the two periphery regions where the corresponding periphery connection line is disposed.

In some embodiments, the respective periphery connection line includes widened portions respectively disposed in the two edge regions and a main body portion disposed in the central region. Each of the widened portions and the main body portion extends along the first direction. A respective widened portion of the widened portions has a first end connected to the main body portion and to a corresponding connecting part of the connecting parts. And in the second direction, a width of the respective widened portion is greater than a width of the main body portion.

In some embodiments, the respective periphery connection line further includes edge portions respectively disposed in the two edge regions and extending along the second direction. A respective edge portion of the edge portions has an end connected to a second end of the respective widened portion. The respective edge portion is connected to first solder joint connection lines of the plurality of solder joint connection lines that are connected to corresponding first finger electrodes of the first finger electrodes and has disconnections at second solder joint connection lines of the plurality of solder joint connection lines that are connected to corresponding second finger electrodes of the second finger electrodes. Or the respective edge portion is connected to the second solder joint connection lines and has disconnections at the first solder joint connection lines.

In some embodiments, the respective solder joint connection line tapers along a direction directing from the central region to a corresponding edge region of the two edge regions where the respective solder joint connection line is disposed.

Another aspect of some embodiments of the present disclosure further provide a photovoltaic module, including at least one cell string formed by connecting a plurality of solar cells, where each solar cell of the plurality of solar cells being described in any of the foregoing embodiments; at least one encapsulating film configured to cover at least one surface of the at least one cell string; and at least one cover plate configured to cover at least one surface of the at least one encapsulating film away from the at least one cell string.

The technical solutions provided by the present disclosure at least have the following advantages:
On the one hand, a solder joint in a portion of two edge regions closest to a periphery of a substrate is configured to be a respective first solder joint with a smaller area of an orthographic projection, rather than a respective second solder joint with a larger orthographic projection area. This configuration is advantageous for disposing second solder joints in a portion of the two edge regions closer a central region, thereby reducing the risk of the second solder joints being subjected to relatively large external force, and reducing a magnitude of external force acting on the second solder joints. This helps lower the probability of cold solder joints or missed solder joints during subsequent soldering of solder strips to the second solder joints as well as the probability of detached solder joints after the subsequent soldering of the solder strips to the second solder joints. On the other hand, as the starting solder joint or the ending solder joint for the subsequent solder strip, the second solder joints is configured to have a larger area of an orthographic projection on the substrate, which not only reduces a transfer resistance of the second solder joints itself, thereby improving the carrier collection efficiency of the second solder joints, but also enhances alignment accuracy and bonding strength between the solder strips and the second solder joints. In addition, this configuration prevents problems such as cold solder joints or detached solder joints caused by excessive force exerted by the solder strips on the respective second solder joint (which serves as the starting solder joint or the ending solder joint), further contributes to improving the carrier collection efficiency of the second solder joints and the bonding reliability between the solder strips and the second solder joints.

In addition, the plurality of solder joint connection lines are configured to be in contact with the first solder joints and the second solder joints, as well as is in contact with a plurality of grid lines disposed on sides of the plurality of second solder joint away from the central region. On the one hand, based on the configuration of the first solder joints, it is advantageous for disposing the second solder joints in the two edge regions closer the central region. Accordingly, the plurality of grid lines disposed on the sides of the second solder joints away from the central region become increased. Therefore, the plurality of solder joint connection lines are in contact with the first solder joints to form integrally, thereby serving as a bus portion. In this way, a volume of the bus portion can be increased, thereby reducing a transmission resistance of the bus portion, thereby enabling the bus portion to match a greater number of grid lines, efficiently collecting carriers from the greater number of grid lines, and improving the transport efficiency of carriers in the solar cell. On the other hand, the first solder joints being disposed on the plurality of solder joint connection lines is beneficial for increasing an area of an orthographic projection of an integrated structure (that is, the bus portion) formed by the plurality of solder joint connection lines and the first solder joints on the substrate, thereby increasing a contact area between the subsequent solder strips and the bus portion, and improving the transport efficiency of carriers in the solar cell.

### BRIEF DESCRIPTION OF THE DRAWINGS

One or more embodiments are illustrated with reference to the accompanying drawings, and such exemplary description does not constitute a limitation on the embodiments. Unless otherwise stated, the figures in the accompanying drawings do not constitute a scale limitation. In order to more clearly illustrate technical solutions in the embodiments of the present disclosure or in the prior art, a brief description of the accompanying drawings used in the embodiments will be provided below. Obviously, the accompanying drawings in the following description illustrate only some embodiments of the present disclosure, and those of ordinary skill in the art may derive other drawings from these drawings without inventive effort.
FIG. 1 is a first schematic diagram of a partial top view of a solar cell according to some embodiments of the present disclosure.
FIG. 2 is a second schematic diagram of a partial top view of a solar cell according to some embodiments of the present disclosure.
FIG. 3 is a third schematic diagram of a partial top view of a solar cell according to some embodiments of the present disclosure.
FIG. 4 is a fourth schematic diagram of a partial top view of a solar cell according to some embodiments of the present disclosure.
FIG. 5 is a fifth schematic diagram of a partial top view of a solar cell according to some embodiments of the present disclosure.
FIG. 6 is a sixth schematic diagram of a partial top view of a solar cell according to some embodiments of the present disclosure.
FIG. 7 is a seventh schematic diagram of a partial top view of a solar cell according to some embodiments of the present disclosure.
FIG. 8 is an eighth schematic diagram of a partial top view of a solar cell according to some embodiments of the present disclosure.
FIG. 9 is a schematic diagram of a partial top view of a periphery connection line of a solar cell according to some embodiments of the present disclosure.
FIG. 10 is another schematic diagram of a partial top view of a periphery connection line of a solar cell according to some embodiments of the present disclosure.
FIG. 11 is a top view of a combination of a solder joint connection line, a first solder joint and a second solder joint according to some embodiments of the present disclosure.
FIG. 12 is a schematic diagram of a partial perspective view of a photovoltaic module according to some embodiments of the present disclosure.
FIG. 13 is a schematic diagram of a partial sectional view of the photovoltaic module in FIG. 12 along a first cross-sectional direction AA1.

Reference numerals in the accompanying drawings:
100. substrate, 110. edge region; 120. central region; 130. soldering region; 1301. first soldering region; 1302. second soldering region; 140. periphery region; 101. grid line; 111. first finger electrode; 121. second finger electrode; 112. first solder joint; 122. second solder joint; 132. third solder joint; 103. solder joint connection line; 104. auxiliary line; 105. periphery connection line; 115. widened portion; 125. main body portion; 135. edge portion; 106. connecting part; 107. solder strip; 40. solar cell; 41. encapsulating film; 42. cover plate; and 43. conductive strip.

### DETAILED DESCRIPTION OF THE EMBODIMENTS

As known from the background, the transport efficiency of carriers in a solar cell needs to be improved.

The present disclosure provides a solar cell and a photovoltaic module. In the solar cell, on the one hand, a solder joint in a portion of two edge regions closest to a periphery of a substrate is configured to be a respective first solder joint with a smaller area of an orthographic projection, rather than a respective second solder joint with a larger area of an orthographic projection. This configuration is advantageous for disposing second solder joints in a portion of the two edge regions closer a central region, thereby reducing the risk of the second solder joints being subjected to relatively large external force, and reducing a magnitude of external force acting on the second solder joints. This helps lower the probability of cold solder joints or missed solder joints during subsequent soldering of solder strips to the second solder joints as well as the probability of detached solder joints after the subsequent soldering of the solder strips to the second solder joints. On the other hand, as the starting solder joint or the ending solder joint for the subsequent solder strip, the second solder joints is configured to have a larger area of an orthographic projection on the substrate, which not only reduces a transfer resistance of the second solder joints itself, thereby improving the carrier collection efficiency of the second solder joints, but also enhances alignment accuracy and bonding strength between the solder strips and the second solder joints. In addition, this configuration prevents problems such as cold solder joints or detached solder joints caused by excessive force exerted by the solder strips on the respective second solder joint (which serves as the starting solder joint or the ending solder joint), further contributes to improving the carrier collection efficiency of the second solder joints and the bonding reliability between the solder strips and the second solder joints. In addition, the plurality of solder joint connection lines are configured to be in contact with the first solder joints and the second solder joints, as well as is in contact with a plurality of grid lines disposed on sides of the plurality of second solder joint away from the central region. On the one hand, based on the configuration of the first solder joints, it is advantageous for disposing the second solder joints in the two edge regions closer the central region. Accordingly, the plurality of grid lines disposed on the sides of the second solder joints away from the central region become increased. Therefore, the plurality of solder joint connection lines are in contact with the first solder joints to form integrally, thereby serving as a bus portion. In this way, a volume of the bus portion can be increased, thereby reducing a transmission resistance of the bus portion, thereby enabling the bus portion to match a greater number of grid lines, efficiently collecting carriers from the greater number of grid lines, and improving the transport efficiency of carriers in the solar cell. On the other hand, the first solder joints being disposed on the plurality of solder joint connection lines is beneficial for increasing an area of an orthographic projection of an integrated structure (that is, the bus portion) formed by the plurality of solder joint connection lines and the first solder joints on the substrate, thereby increasing a contact area between the subsequent solder strips and the bus portion, and improving the transport efficiency of carriers in the solar cell.

In the description of the embodiments of the present disclosure, the technical terms "first," "second," and the like, are merely used to distinguish one element from another and should not be construed as indicating or implying relative importance, or implying the number, specific sequence, or priority of the technical features being described. In the description of the embodiments of the present disclosure, "plurality" means two or more, unless expressly specified otherwise.

Any reference to "embodiment(s)" herein means that particular features, structures, or characteristics described in combination with the embodiment(s) may be included in at least some embodiments of the present disclosure. A phrase appearing in various places in the specification does not necessarily refer to the same embodiment, nor is an independent or alternative embodiment mutually exclusive with other embodiments. It is explicitly and implicitly understood by those skilled in the art that the embodiments described herein may be combined with other embodiments.

In the description of embodiments of the present disclosure, the term "and/or" merely indicates an association relationship describing associated objects, indicating that there may be three types of relationships, for example, A and/or B, which means three possible cases, that is, the existence of A alone, the existence of both A and B, and the existence of B alone. In addition, the character "/" herein generally indicates that the associated objects are in an "or" relationship.

In the description of embodiments of the present disclosure, the term "a plurality of" means two or more (including two). Similarly, the term "a plurality of groups" means two or more groups (including two groups), and the term "a plurality of pieces" means two or more pieces (including two pieces).

In the description of the present disclosure, the terms "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential" and other indicated orientations or positional relationships are based on the orientations or positional relationships shown in the accompanying drawings, and are only for the convenience of describing the embodiments of the present disclosure and simplifying the description, rather than indicating or implying that indicated devices or elements must have a particular orientation, be constructed and operate in a particular orientation and are therefore not to be construed as limitations to the embodiments of the present disclosure.

In the description of the embodiments of present disclosure, it should be noted that, unless otherwise explicitly specified and defined, the technical terms "mounting", "connecting" and "connection" should be understood in a broad sense, for example, they may be a fixed connection, a detachable connection, or an integrated connection; may be a mechanical connection, or an electrical connection; and may be a direct connection, or an indirect connection via an intermediate medium, or communication inside two elements. For those of ordinary skill in the art, specific meanings of the above terms in the embodiments of the present disclosure could be understood according to specific circumstances.

In the drawings corresponding to the embodiments of the present disclosure, for better understanding and ease of illustration, the thicknesses and sizes of layers are enlarged. When describing that a component (such as a layer, film, region, or substrate) is referred to as being "on" another component or "on a surface of another component", the component may be directly on the surface of the other component, or a third component may be disposed between the two components. Conversely, when one component is described as being on the surface of another component, or that one component is describe as being formed or disposed on the surface of another component, it indicates that no third component exists between the two components. Furthermore, when a component is referred to as being "substantially formed on" another component, it means that the component is not formed over the entire surface (or front side) of the other component, nor merely on a portion of an edge thereof.

In the description of the embodiments of the present disclosure, when a certain component is referred to as "including" another component, unless otherwise specified, it does not exclude the presence of other components, and such other components may also be included. Furthermore, when a component such as a layer, film, region, or plate is referred to as being "on" or "disposed on" another component, it may be "directly on" the other component (that is, disposed on a surface of the other component with no other components in between), or there may be other components interposed between the same. Moreover, when a layer, film, region, or plate is "directly on" another component, or when a layer, film, region, or plate is disposed on the surface of another component, it indicates that no other components are present between them.

The terminology used in the description of the various embodiments herein is intended solely to describe specific embodiments and is not intended to be limiting. As used in the description of the various embodiments and in the appended claims, the singular forms are intended to include the plural forms, unless the context clearly dictates otherwise. The component includes, but is not limited to, a layer, a film, a region, or a plate.

The embodiments of the present disclosure will be described in detail below with reference to accompanying drawings. However, those of ordinary skill in the art may understand that in each embodiment of the present disclosure, many technical details have been put forward in order to make readers better understand the present disclosure. Nevertheless, even without these technical details and various changes and modifications based on the embodiments below, technical solutions to be protected according to the embodiments of the present disclosure may be substantially implemented.

Some embodiments of the present disclosure provide a solar cell, which will be described in detail below with reference to the accompanying drawings.

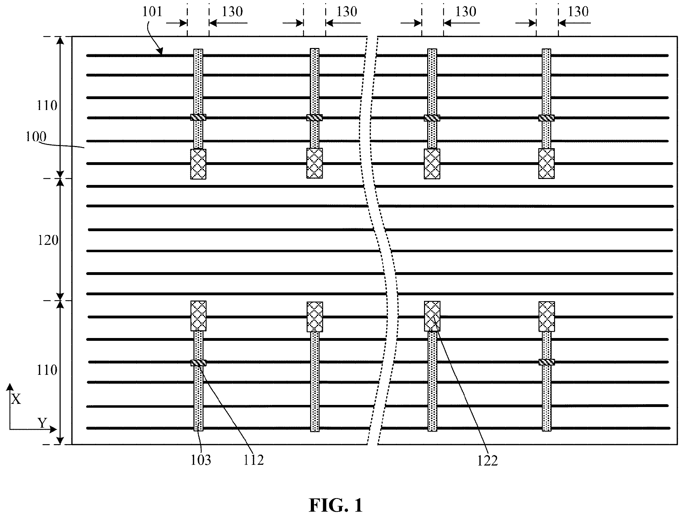

Referring to any one of FIGS. 1 to 3 and FIG. 4, the solar cell includes: a substrate 100, a side of the substrate 100 being divided into two edge regions 110 opposite to each other and a central region 120 between the two edge regions; a plurality of grid lines 101 disposed on the substrate 100 and positioned at intervals along a first direction X; first solder joints 112 and second solder joints 122 disposed in the two edge regions 110, where the first solder joints 112 being positioned at intervals along a second direction Y perpendicular to the first direction X, the second solder joints 122 being positioned at intervals along the second direction Y and closer to the central region 120 than the first solder joints 112, and an area of an orthographic projection of a respective first solder joint 112 of the first solder joints 112 on the substrate 100 is smaller than an area of an orthographic projection of a respective second solder joint 122 of the second solder joints 122 on the substrate 100; and a plurality of solder joint connection lines 103 disposed in the two edge regions 110. A respective solder joint connection line 103 of the plurality of solder joint connection lines 103 is connected to a corresponding first solder joint 112 of the first solder joints 112, to a corresponding second solder joint 122 of the second solder joints 122, and to grid lines 101 of the plurality of grid lines 101 disposed on a side of the corresponding second solder joints 122 away from the central region 120.

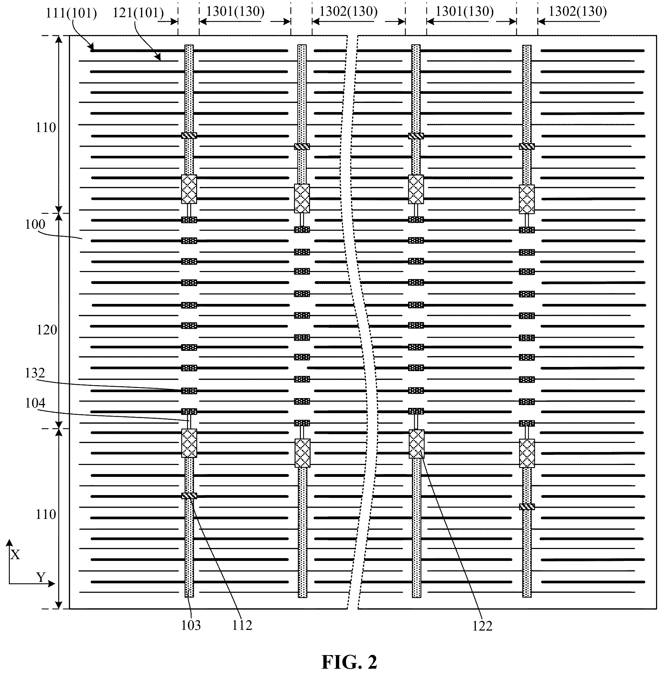

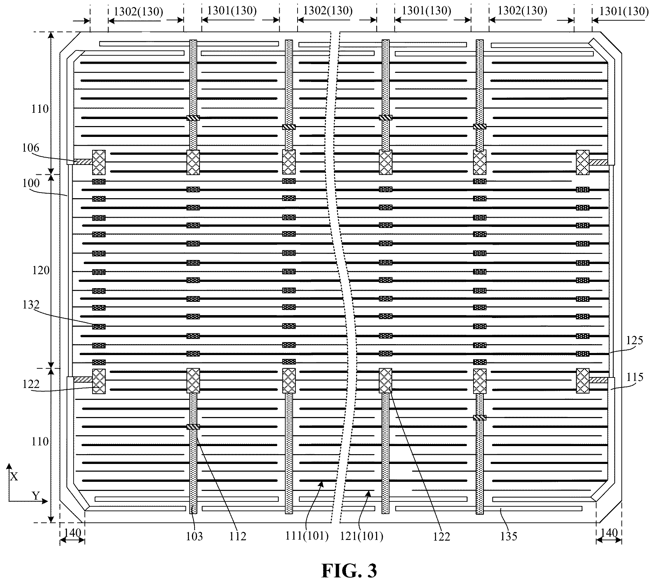

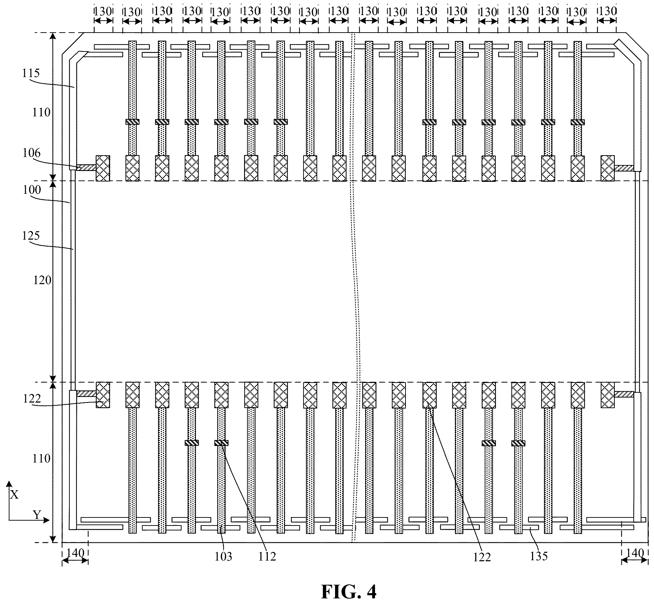

FIG. 1 is a first schematic diagram of a partial top view of a solar cell according to some embodiments of the present disclosure. FIG. 2 is a second schematic diagram of a partial top view of a solar cell according to some embodiments of the present disclosure. FIG. 3 is a third schematic diagram of a partial top view of a solar cell according to some embodiments of the present disclosure. FIG. 4 is a fourth schematic diagram of a partial top view of a solar cell according to some embodiments of the present disclosure. It should be noted that FIGS. 1 to 4 illustrate two sides of the solar cell along a second direction Y using truncated wavy lines drawn with dashed lines. To clearly illustrate a layout of the first solder joints 112 and the second solder joints 122 on the substrate 100, the plurality of grid lines 101 are omitted in FIG. 4 for clarity.

Herein, the first direction X refers to a direction in which the two edge regions 110 and the central region 120 are disposed. In addition, the first direction X also refers to a direction to perpendicular to an extension direction of the central region 120. A second direction refers to a direction parallel to the extension direction of the central region 120. In addition, the second direction also refers to an extension direction of each of the two edge regions 110.

Herein, the substrate 100 refers to a component or product that is pre-produced and may be also referred to as a cell base. The substrate 100 may be a combination of a silicon substrate and various functional film layers formed over the silicon substrate. In some embodiments, the functional film layers formed over the silicon substrate may include a passivation layer and an anti-reflection layer. In some other embodiments, the functional film layers formed over the silicon substrate may further include a doped silicon layer. In other words, the substrate 100 may include functional film layers according to actual needs.

It is worth noting that, in the first direction X, A solder joint in the two edge regions 110 closest to a periphery of the substrate 100 is the respective first solder joint 112 with a smaller area of an orthographic projection on the substrate 100, rather than the respective second solder joint 122 with a larger area of an orthographic projection on the substrate 100. In other words, a solder joint closest to a side of the substrate 100 along the first direction X is not a solder joint with the largest area of an orthographic projection. In addition, the respective second solder joint 122 may be considered as a starting solder joint where a solder strip starts soldering on the solar cell, when the solder strip is in electrical contact with the solar cell, or may be considered as an ending solder joint where the solder strip completes soldering on the solar cell, when the solder strip is in electrical contact with the solar cell. In some embodiments, when the solder strip is in contact with the respective second solder joint 122, the solder strip exerts a greater force on the respective second solder joint 122, serving as the starting solder joint or the ending solder joint, than on the first solder joints 112. Moreover, the two edge regions 110 are also susceptible to greater external force than the central region 120, portions of the two edge regions 110 facing the periphery of the substrate 100 is susceptible to increasing external force along a direction from the central region 120 to the respective edge region 110 parallel to the first direction X.

Accordingly, on the one hand, the solder joint in the two edge regions 110 closest to the periphery of the substrate 100 is configured to be the respective first solder joint 112 with a smaller area of an orthographic projection, rather than the respective second solder joint 122 with a larger area of an orthographic projection. Compared with disposing the respective first solder joint 112 in the two edge regions 110 closer the central region 120, this configuration is advantageous for disposing the respective second solder joint 122 in the two edge regions 110 closer the central region 120, thereby reducing the risk of the second solder joints 122 being subjected to relatively large external force, and reducing a magnitude of external force acting on the second solder joints 122. This helps lower the probability of cold solder joints or missed solder joints during subsequent soldering of the solder strips to the second solder joints 122 as well as the probability of detached solder joints after the subsequent soldering of the solder strips to the second solder joints 122. On the other hand, as the starting solder joint or the ending solder joint for the subsequent solder strips, the respective second solder joints 122 is configured to have a larger area of an orthographic projection on the substrate 100, which not only reduces a transfer resistance of the respective second solder joint 122 itself, thereby improving the carrier collection efficiency of the respective second solder joint 122, but also enhances alignment accuracy and bonding strength between the solder strips and the respective second solder joint 122. In addition, this configuration prevents problems such as cold solder joints or detached solder joints caused by excessive force exerted by the solder strips on the respective second solder joint 122 (which serves as the starting solder joint or the ending solder joint), further contributes to improving the carrier collection efficiency of the respective second solder joint 122 and the bonding reliability between the solder strips and the respective second solder joint 122.

In addition, the respective solder joint connection line 103 is connected to a corresponding first solder joint 112 of the first solder joints 112, to a corresponding second solder joint 122 of the second solder joints 122, and to grid lines 101 of the plurality of grid lines 101 disposed on a side of the corresponding second solder joint 122 away from the central region 120. In this way, the respective solder joint connection line 103 cannot only electrically connect the corresponding first solder joint 112 to the corresponding second solder joint 122, but also collect carriers from the grid lines 101 on the side of the corresponding second solder joints 122 away from the central region 120, ultimately transporting the carriers to the corresponding first solder joint 112 and/or the corresponding second solder joint 122. Moreover, on the one hand, based on the configuration of the respective first solder joint 112, it is advantageous for disposing the respective second solder joint 122 in the two edge regions 110 closer the central region 120. Accordingly, the grid lines 101 disposed on the side of the corresponding second solder joint 122 away from the central region 120 become increased. Since the plurality of solder joint connection lines 103 need to collect carriers from the increased grid lines 101, the respective solder joint connection line 103 is configured to connect with the corresponding first solder joint 112 to form integrally, thereby serving as a bus portion. In this way, a volume of the bus portion can be increased, thereby reducing a transmission resistance of the bus portion, thereby enabling the bus portion to match a greater number of grid lines 101, efficiently collecting carriers from the greater number of grid lines 101, and improving the transport efficiency of carriers in the solar cell. On the other hand, the corresponding first solder joints 112 being disposed on the respective solder joint connection line 103 is beneficial for increasing an area of an orthographic projection of an integrated structure (that is, the bus portion) formed by the respective solder joint connection line 103 and the corresponding first solder joints 112 on the substrate 100, thereby increasing a contact area between the subsequent solder strips and the bus portion, and improving the transport efficiency of carriers in the solar cell.

It is worth emphasizing that, in some embodiments, the subsequent solder strips are configured in contact with the second solder joints 122 and at least some of the first solder joints 112, thereby improving the carrier collection efficiency of the solder strip. In some embodiments, through respective solder joint connection line 103, the corresponding first solder joint 112 and the corresponding second solder joint 122 are in electrical connection. Therefore, the subsequent solder strips may not be in contact with the corresponding first solder joint 112; and carriers in the corresponding first solder joint 112 may be transported to the corresponding second solder joint 122 through the respective solder joint connection line 103, which further contributes to improving the yield of the solar cell.

In some embodiments, referring to FIG. 1, the solar cell may have grid lines 101 on both sides. For example, the solar cell may be a passivated emitter and rear cell (PERC), a tunnel oxide passivated contact (TOPCon) cell, a heterojunction technology (HIT/HJT) cell, a thin-film solar cell, or a tandem solar cell, or any combination thereof. The thin-film solar cell includes, but is not limited to, a perovskite thin-film solar cell, a copper indium selenide thin-film solar cell, a gallium arsenide thin-film solar cell, or a cadmium sulfide thin-film solar cell. The tandem solar cell includes, but is not limited to, a perovskite solar cell stacked on a crystalline silicon solar cell, a perovskite solar cell stacked on another perovskite solar cell, or a perovskite solar cell stacked on a thin-film solar cell.

It should be noted that the substrate 100 has a front side and a back side opposite to each other. A third direction is a thickness direction of the substrate 100. Each of the front side and the back side of the substrate 100 may be divided into two edge regions 110 opposite to each other along the first direction X and a central region 120 between the two edge regions 110, as shown in FIG. 1. A plurality of grid lines 101, first solder joints 112, second solder joints 122, and solder joint connection lines 103 disposed on either the front side or the back side may be configured as shown in FIG. 1. In addition, the layout of the first solder joints 112 and the second solder joints 122 on the substrate 100 as illustrated in FIG. 4 may also be applicable to a solar cell having the grid lines 101 on both sides.

In some embodiments, referring to FIGS. 2, 3, or 4, the solar cell may be a back contact (BC) solar cell. The BC solar cell includes, but is not limited to, an interdigitated back contact (IBC) solar cell, a heterojunction back contact (HBC) solar cell, a TOPCon back contact (TBC) solar cell or a hybrid passivated back contact (HPBC) solar cell, etc.

It should be noted that the back contact solar cell will be described in detail below. Moreover, when the following description does not emphasize that the solar cell is a back contact solar cell, the detailed design for the solar cell can be applied not only to a solar cell with the grid lines 101 on both sides, but also to a back contact solar cell.

It is worth emphasizing that a single solar cell may be in the form of either a full-size solar cell or a plurality of sliced solar cells. In other words, the solar cell may be a full-size solar cell or a sliced solar cell, where the sliced solar cell refers to a solar cell obtained by cutting a complete full-size solar cell through a singulation process, such as a half-cut solar cell. In some embodiments, the solar cell may be a monocrystalline silicon solar cell, a polycrystalline silicon solar cell, an amorphous silicon solar cell or a multi-compound solar cell, where the multi-compound solar cell may specifically be a cadmium sulfide solar cell, a gallium arsenide solar cell, a copper indium selenide solar cell or a perovskite solar cell.

Some embodiments of the present disclosure will be further described in detail below in conjunction with the accompanying drawings.

In some embodiments, referring to FIGS. 1 to 3, a number of grid lines 101 of the plurality of grid lines 101 connected with a respective first solder joint 112 of the first solder joints 112 may be less than or equal to a number of grid lines 101 of the plurality of grid lines 101 connected with a respective second solder joint 122 of the second solder joints 122.

In some embodiments, referring to FIG. 1 or 3, a number of grid lines 101 of the plurality of grid lines 101 connected with a respective first solder joint 112 of the first solder joints 112 may be equal to a number of grid lines 101 of the plurality of grid lines 101 connected with a respective second solder joint 122 of the second solder joints 122. In some examples, still referring to FIG. 1 or 3, a respective first solder joint 112 of the first solder joints 112 may be connected with only one grid line 101 of the grid lines 101, and a respective second solder joint 122 may also be connected with only one grid line 101 of the grid lines 101.

In some embodiments, referring to FIG. 2 or 3, a number of grid lines 101 of the plurality of grid lines 101 connected with a respective first solder joint 112 of the first solder joints 112 may be less than a number of grid lines 101 of the plurality of grid lines 101 connected with a respective second solder joint 122 of the second solder joints 122. In some examples, still referring to FIG. 2 or 3, a respective first solder joint 112 of the first solder joints 112 may be connected with only one grid line 101 of the grid lines 101, and a respective second solder joint 122 of the second solder joints 122 may also be connected with two corresponding grid lines 101 of the grid lines 101 adjacent to the respective second solder joint 122 along the first direction X.

It should be noted that, in FIGS. 2 and 3, first finger electrodes 111 are schematically illustrated by thick solid lines, and second finger electrodes 121 are schematically illustrated by thin solid lines. In addition, by way of examples, in FIG. 2, a respective second solder joint 122 of the second solder joints 122 disposed in a respective first soldering region 1301 of the first soldering regions 1301 is in contact with two corresponding first finger electrodes 111 of the first finger electrodes 111 adjacent to the respective second solder joint 122, and a respective second solder joint 122 of the second solder joints 122 disposed in second soldering regions 1302 is in contact with two corresponding second finger electrodes 121 of the second finger electrodes 121 adjacent to the respective second solder joint 122. In FIG. 3, by way of examples, a respective second solder joint 122 of the second solder joints 122 disposed in a respective first soldering region 1301 of the first soldering regions 1301 is in contact with two corresponding first finger electrodes 111 of the first finger electrodes 111 adjacent to the respective second solder joint 122, and a respective second solder joint 122 of the second solder joints 122 disposed in the second soldering regions 1302 is in contact with one corresponding second finger electrode 121 of the second finger electrodes 121.

It should be noted that, based on the area of the orthographic projection of the respective first solder joint 112 on the substrate 100 being smaller than that of the respective second solder joint 122 on the substrate 100, the number of the grid lines 101 in contact with a respective first solder joint 112 of the first solder joints 112 is configured to be less than the number of the grid lines 101 in contact with a respective second solder joint 122 of the second solder joints, which is advantageous for making full use of the larger area of the orthographic projection of the respective second solder joint 122 on the substrate 100 to enhance a current collection effect of the respective second solder joint 122, enabling carriers from a greater number of grid lines 101 to be transported more rapidly to the respective second solder joint 122. Consequently, a denser carrier collection network is established, which reduces a transport distance of photo-generated carriers and a series resistance of the solar cell.

In some embodiments, referring to FIGS. 1 to 4, the side of the substrate 100 may be divided into a plurality of soldering regions 130 positioned at intervals along the second direction Y. The plurality of soldering regions 130 have overlapping regions where one corresponding soldering region 130 of the plurality of soldering regions 130 overlaps with one corresponding edge region 110 of the two edge regions 110. Each overlapping region of at least some of the overlapping regions has one corresponding second solder joint 122 of the second solder joints 122. At least a portion of the overlapping regions have one corresponding first solder joint 112 of the first solder joints 112, and at least a portion of the overlapping regions have one corresponding solder joint connection line 103 of the plurality of solder joint connection lines 103. In other words, the side of the substrate is further divided into a plurality of soldering regions 130 positioned at intervals along a second direction Y and overlapped the two edge regions 110, and two corresponding second solder joints 122 of the second solder joints 122, at least one corresponding first solder joint 112 of the first solder joints 112, and at least one corresponding solder joint connection line 103 of the plurality of solder joint connection lines 103 are disposed in a respective soldering region 130 of the plurality of soldering regions 130.

It is worth noting that one corresponding soldering region 130 of the plurality of soldering regions 130 corresponds to one corresponding solder strip of the solder strips. The regions where one corresponding soldering region 130 of the plurality of soldering regions 130 overlaps with one corresponding edge region 110 of the two edge regions 110, i.e., the overlapping regions, which may be regarded as starting soldering joints or ending soldering joints of the subsequent solder strips on the substrate 100. The one corresponding soldering region 130 has two overlapping regions that respectively overlap with the two edge regions 110 opposite to each other along the first direction X. One of the two overlapping regions serves as a starting soldering joint for the subsequent solder strips, and the other serves as an ending soldering joint for the subsequent solder strips. Accordingly, since each overlapping region of at least some of the overlapping regions has a second solder joint 122, a corresponding soldering region 130 has two second solder joints 122 opposite to each other along the first direction X. One of the two second solder joints 122 in the same respective soldering region 130 serves as the starting solder joint, and the other serves as the ending solder joint.

It should be noted that "overlapping regions" mentioned here and hereinafter are virtual regions artificially divided for accurately positioning and describing forming positions of components such as the first solder joints, the second solder joints and the plurality of solder joint connection lines, rather than inherent functional regions of the substrate 100, nor a part of a manufactured solar cell or a cell string. In actual production, each overlapping region of at least some of the overlapping regions on a side of the substrate 100 may for example be determined or positioned by means of computer-aided drawing, visual recognition, etc. The above description on "overlapping regions" is also applicable to "soldering regions", "edge regions", or the like that are derived by artificially dividing in the present disclosure.

In some embodiments, referring to FIGS. 1 to 4, a force applied by the solder strips at the starting solder joint is greater than that at the ending solder joint. Therefore, the respective first solder joint 112 may be disposed only on a side of the respective second solder joints 122, serving as the starting solder joint, away from the central region 120, and the respective first solder joint 112 may also be disposed on a side of the respective second solder joint 122, serving as the ending solder joint, away from the central region 120.

In some embodiments, a respective first solder joint of the first solder joints may be disposed only on a side of a respective second solder joint, serving as the starting solder joint, of the two second solder joints disposed in the one corresponding soldering region of the soldering region away from the central region, while a respective second solder joint of the two second solder joints serving as the ending solder joint may not have a respective first solder joint adjacent to a side away from the central region.

In some embodiments, referring to FIG. 4, in a respective soldering region 130 of the plurality of soldering regions 130, no first solder joint 112 may be disposed on each side of a respective second solder joint 122 of the two second solder joints 122 away from the central region 120. While in a respective soldering region 130 of the plurality of soldering regions 130, a respective first solder joint 112 of the first solder joints 112 may be disposed each side of a respective second solder joint 122 of the two second solder joints 122 away from the central region 120.

It should be noted that, in some embodiments, the respective first solder joint may be disposed on the side of the respective second solder joint away from the central region according to actual requirements. In this way, the connection stability between the subsequent solder strips and the integrated structure which is formed by the respective solder joint connection line and the respective first solder joint in the respective soldering region can be improved, thereby effectively reducing the probability of abnormalities occurring in the respective soldering region during the soldering and reliability testing of the solar cell, further improving the yield of the solar cell after soldering. A positional relationship between the respective first solder joint 112 and the respective second solder joint 122 illustrated in some embodiments of the present disclosure is merely exemplary.

In some embodiments, referring to FIG. 3 or 4, since the magnitude of external force applied to different soldering regions 130 may vary, one corresponding first solder joint 112 of the first solder joints 112 is configured to dispose on at least a portion of the overlapping regions, and one corresponding solder joint connection line 130 of the plurality of solder joint connection lines 103 is configured to dispose on at least a portion of the overlapping regions. This configuration enables the effective improvement of transport efficiency of carriers in the solar cell by means of the first solder joints 112, while controlling the number of the first solder joints 112 and the plurality of solder joint connection lines 103 reasonably to control the consumption of raw materials required for fabrication of the first solder joints 112 and the plurality of solder joint connection lines 103, thereby controlling the fabrication cost of the solar cell. In other words, it is not necessary for the second solder joints 122 to correspond one-to-one with the first solder joints 112, and it is also not necessary for the plurality of solder joint connection lines 103 to correspond one-to-one with the first solder joints 112.

In some examples, still referring to FIG. 3 or 4, first solder joints 112 are configured in a plurality of soldering regions 130 that are more susceptible to greater external force than in a plurality of soldering region 130 that is subjected to smaller external force. In this way, a contact area between the plurality of solder joint connection lines 103 of the first solder joints 112 and the solder strips can be increased, thereby enhancing a connection strength between the solder strips and the integrated structure that is formed by the plurality of solder joint connection lines 103 and the first solder joints 112, further reducing the probability that the solder strip will detach from the plurality of solder joint connection lines 103 or the first solder joints 112 due to greater external force.

In some examples, still referring to FIG. 3 or 4, the side of the substrate 100 is further divided into two periphery regions 140 opposite to each other. Compared with a respective soldering region 130 of the plurality of soldering regions 130 away from the two periphery regions 140, a respective first solder joint 112 of the first solder joints 112 is disposed in a respective soldering region 130 of the plurality of soldering regions 130 close to the two periphery regions 140. This configuration is beneficial for enhancing the connection stability between the subsequent solder strips and the integrated structure formed by the respective solder joint connection line 103 and the respective first solder joints 112 in the respective soldering regions 130, thereby effectively reducing the probability of abnormalities occurring in the plurality of soldering regions 130 during the soldering and reliability testing of the solar cell, further improving the yield of the solar cell after soldering.

In some embodiments, referring to FIG. 3 or 4, the side of the substrate 100 is further divided into two periphery regions 140 opposite to each other. In the two soldering regions 130 closest the two periphery regions 140, two respective second solder joints 122 of the second solder joints 122 opposite to each other in the first direction X may be disposed, without the first solder joints 112 or the plurality of solder joint connection lines 103.

It should be noted that the abovementioned various configurations may be simultaneously implemented in a same solar cell or may be applied separately in different solar cells. The solar cell may have grid lines 101 on both sides or may be a back contact solar cell.

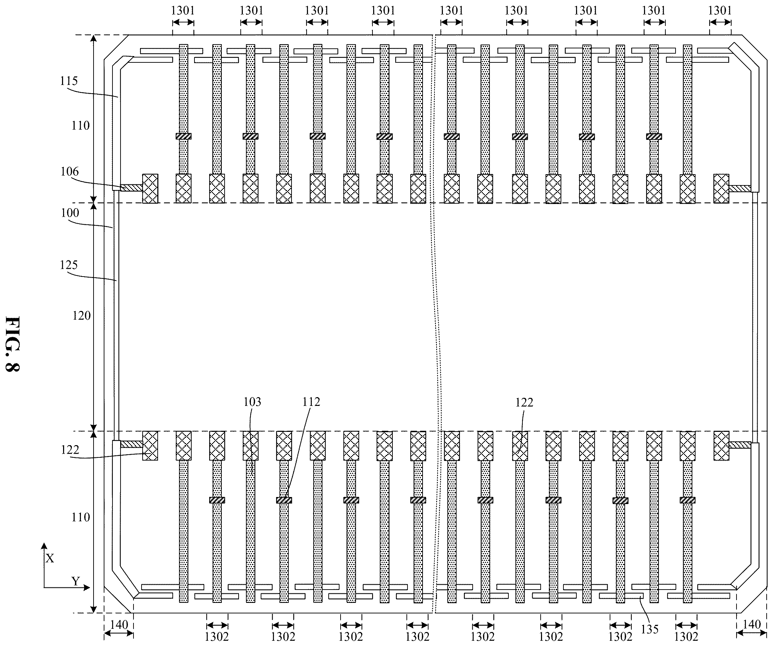

In some embodiments, referring to FIG. 8, which is an eighth schematic diagram of a partial top view of a solar cell according to some embodiments of the present disclosure. The solar cell may be a back contact solar cell. A side of the substrate 100 is divided into a plurality of first soldering regions 1301 and a plurality of second soldering regions 1302 positioned at intervals along the second direction Y. A plurality of grid lines 101 (see FIG. 3) include alternating first finger electrodes 111 (see FIG. 3) and second finger electrodes 121 (see FIG. 3) along the first direction X. The first soldering regions 1301 and the second soldering regions 1302 include first overlapping regions and second overlapping regions. The first overlapping regions and second overlapping regions included in the first soldering regions 1301 are defined as regions where the first soldering regions 1301 overlap with the two edge regions 110. The first overlapping regions and second overlapping regions included in the second soldering regions 1302 are defined as regions where the second soldering regions 1302 overlap with the two edge regions 110. Only one of the first overlapping regions and the second overlapping regions included in the first soldering regions 1301 has the first solder joints 112, and only the other of the first overlapping regions and the second overlapping regions included in the second soldering regions 1302 has the first solder joints 112. In other words, the side of the substrate is divided into a plurality of soldering regions 130 positioned at intervals along a second direction Y, and overlapped the two edge regions 110. The first solder joints 112 are disposed alternately on both sides of the central region 120, and a respective first solder joint 112 of the first solder joints 112 is disposed in a corresponding soldering region 130 of the plurality of soldering regions 130.

It should be noted that FIG. 8 illustrates two sides of the solar cell along a second direction Y using truncated wavy lines drawn with dashed lines. To clearly illustrate the layout of the first solder joints 112 and the second solder joints 122 on the substrate 100, the grid lines 101 are omitted in FIG. 8 for clarity.

Generally, in a back contact solar cell, solder strips for collecting carriers from a plurality of first finger electrodes 111 are defined as first solder strips and disposed in the first soldering regions 1301. Solder strips for collecting carriers from a plurality of second finger electrodes 121 are defined as second solder strips and disposed in the second soldering regions 1302. Due to different current transmission directions, starting soldering joints of the first solder strips and the second solder strips on the substrate 100 are disposed opposite to each other along the first direction X, such that the second solder joints 122 serving as the starting solder joint in the first soldering region 1301 is disposed in one of the first overlapping regions and the second overlapping regions, while the second solder joints 122 serving as the starting solder joint in the second soldering regions 1302 is disposed in the other of the first overlapping regions and the second overlapping regions. FIG. 8 illustrates an example where the second solder joints 122 serving as the starting solder joint in the first soldering region 1301 is disposed in the first overlapping region, and the second solder joints 122 serving as the starting solder joint in the second soldering region 1302 is disposed in the second overlapping region.

Accordingly, starting solder joints in the first soldering regions 1301 and adjacent second soldering regions 1302 along the second direction Y are disposed alternately along the first direction X. The first solder joints 112 are disposed on adjacent to sides of the second solder joints 122 serving as the starting solder joints away from the central region 120. Accordingly, a plurality of first solder joints 112 are disposed alternately along the first direction X. In this way, a projected overlapping area between the solder strips and the overlapping region corresponding to the second solder joints 122 serving as the starting solder joint through the first solder joints 112, thereby improving the connection stability between the solder strips and the integrated structure formed by the first solder joints 112, the second solder joints 122, and the plurality of solder joint connection lines 103. This configuration also prevents problems such as cold solder joints or detached solder joints caused by excessive force exerted by the solder strips on the regions near the second solder joints 122 serving as the starting solder joints, and further improves the carrier collection efficiency of the second solder joints 122.

It is worth emphasizing that, referring to FIG. 8, grid lines 101 (see FIG. 3) that are in contact with the first solder joints 112 and the second solder joints 122 in the first soldering regions 1301 are defined as first finger electrodes 111 (see FIG. 3). Grid lines 101 (see FIG. 3) that are in contact with the first solder joints 112 and the second solder joints 122 in the second soldering regions 1302 are defined as second finger electrodes 121 (see FIG. 3).

In some embodiments, referring to FIGS. 3 to 8, the side of the substrate 100 is further divided into two periphery regions 140 opposite to each other along the second direction Y. In the two soldering regions 130 closest to the two periphery regions 140, two second solder joints 122 opposite to each other in the first direction X may be disposed, without the first solder joints 112 or the plurality of solder joint connection lines 103. In the grid lines 101 disposed in the two edge regions 110 that are not in contact with the second solder joints 122, carriers in the grid lines 101, which have same polarities as the grid lines 101 in contact with the second solder joints 122 closest the two periphery regions 140, are collected by a periphery connection line 105 and ultimately transported to the second solder joints 122 closest to the two periphery regions 140. It should be noted that the periphery connection line 105 will be described in detail below.

In some embodiments, referring to FIG. 4, the side of the substrate 100 may be divided into a plurality of soldering regions 130 positioned at intervals along the second direction Y. The plurality of soldering regions 130 have first overlapping regions where the plurality of soldering regions 130 overlap with one of the two edge regions 110, and second overlapping regions where the plurality of soldering regions 130 overlap with the other of the two edge regions 110. Respective first overlapping regions of the first overlapping regions have the first solder joints 112, and respective second overlapping regions of the second overlapping regions have the first solder joints 112. A number of the respective first overlapping regions having the first solder joints 112 is greater than a number of the respective second overlapping regions having the first solder joints 112. In other words, the side of the substrate is divided into a plurality of soldering regions 130 positioned at intervals along the second direction Y and overlapped the two edge regions 110, a respective first solder joint 112 of the first solder joints 112 is disposed in a corresponding soldering region 130 of the plurality of soldering regions 130, and a number of first solder joints 112 disposed on a first side of the central region 120 is greater than a number of first solder joints 112 disposed on an opposing second side of the central region 120.

In some embodiments, referring to FIG. 4, the solar cell may have grid lines on both sides. The second solder joints 122 disposed on the first overlapping region may be considered as the starting solder joints. Accordingly, the number of the first overlapping regions having the first solder joints 112 is configured to be greater than that of the second overlapping regions having the first solder joints 112, that is, the number of the first solder joints 112 disposed on the first side of the central region 120 is greater than the number of the first solder joints 112 disposed on the opposing second side of the central region 120, thereby facilitating an increase in a projected overlapping area between the solder strips and the first overlapping regions through the first solder joints 112, thereby improving the connection stability between the solder strips and the integrated structure formed by the first solder joints 112, the second solder joints 122, and the plurality of solder joint connection lines 103. This configuration also prevents problems such as cold solder joints or detached solder joints caused by excessive force exerted by the solder strips on the regions close to the second solder joints 122 serving as the starting solder joints, and further improves the carrier collection efficiency of the second solder joints 122.

In some embodiments, referring to FIG. 4, the solar cell may be a back contact solar cell, and a single solar cell may be a half-cut back contact solar cell. When two second overlapping regions of two adjacent half-cut back contact solar cells along the first direction X are adjacent, among two first overlapping regions of the two adjacent half-cell back contact solar cells along the first direction X, a second solder joint 122 in one of the first overlapping regions in contact with the first finger electrode 111 (see FIG. 3) may serve as a starting soldering joint, and a second solder joint 122 (see FIG. 3) in the other of the first overlapping regions in contact with the second finger electrode 121 may serve as a starting soldering joint. It should be noted that a single solar cell being a half-cut back contact solar cell will be described in detail below.

Accordingly, the number of first overlapping regions having the first solder joints 112 is configured to be greater than that of the second overlapping regions having the first solder joints 112, facilitating an increase in a projected overlapping area between the solder strips and the first overlapping regions through the first solder joints 112, thereby improving the connection stability between the solder strips and the integrated structure formed by the first solder joints 112, the second solder joints 122, and the plurality of solder joint connection lines 103. This configuration also prevents problems such as cold solder joints or detached solder joints caused by excessive force exerted by the solder strips on the regions close to the second solder joints 122, which serves as the starting solder joint, and further improves the carrier collection efficiency of the second solder joints 122.

In some embodiments, still referring to FIG. 4, the substrate 100 further includes two periphery regions 140 opposite to each other along the second direction Y. In any one of the two edge regions 110, the first solder joints 112 are disposed in only at least a portion of the overlapping regions facing the two periphery regions 140, while no first solder joint 112 is disposed on the overlapping regions away from the two periphery regions 140. This configuration prevents problems such as cold solder joints or detached solder joints caused by excessive external force on the second solder joints 122 serving as the starting solder joints facing the two periphery regions 140.

It should be noted that, regardless of whether the solar cell is a back contact solar cell or a solar cell having grid lines on both sides, a structure of the solar cell may be configured such that only the overlapping regions facing the two periphery regions are provided with the first solder joints, while the overlapping regions away from the two periphery regions are not provided with the first solder joints.

In some embodiments, still referring to FIG. 4, the second overlapping regions having the first solder joints 112 are defined as target overlapping regions, and first overlapping regions disposed directly opposite to the target overlapping regions along the first direction X include the first solder joints 112. In other words, for the second overlapping regions having the first solder joints 112, the first overlapping regions and the second overlapping regions belong to the same soldering region 130, and the first overlapping regions also include the first solder joints 112. That is, one respective soldering region 130 of the plurality of soldering regions 130 has a first solder joint 112 disposed on the second side and in the respective soldering region 130 further has a first solder joint 112 disposed on the first side and in the respective soldering region 130.

It should be noted that, regardless of whether the solar cell is a back contact solar cell or a solar cell having grid lines on both sides, a structure of the solar cell may be configured to include first solder joints on the first overlapping regions disposed directly opposite the target overlapping regions along the first direction.

In some embodiments, still referring to FIG. 4, the side of the substrate is divided into even number of soldering regions 130 having even number of target overlapping regions, the even number of target overlapping regions are defined as even number of second overlapping regions having the first solder joints 112, the even number of soldering regions are axially symmetric about a central axis along the first direction X, and the even number of target overlapping regions are axially symmetric about the central axis. In other words, both a number of the first solder joints 112 disposed on the second side and a number of the plurality of soldering regions 130 are even numbers, and either the plurality of soldering regions 130 or the first solder joints 112 disposed on the second side are in axially symmetric arrangement about a central axis along the first direction X.

In some examples, still referring to FIG. 4, the side of the substrate 100 is further divided into two periphery regions 140 opposite to each other along the second direction Y. Along the second direction Y, each of a fourth second overlapping region and a fifth second overlapping region facing either of the two periphery regions 140 has the first solder joints 112, while no first solder joint 112 is disposed on the other second overlapping regions.

In some embodiments, the side of the substrate is divided into a plurality of soldering regions 130 in a ranging from 16 to 24, such as 17, 18, 19, 20, 21, 22, or 23.

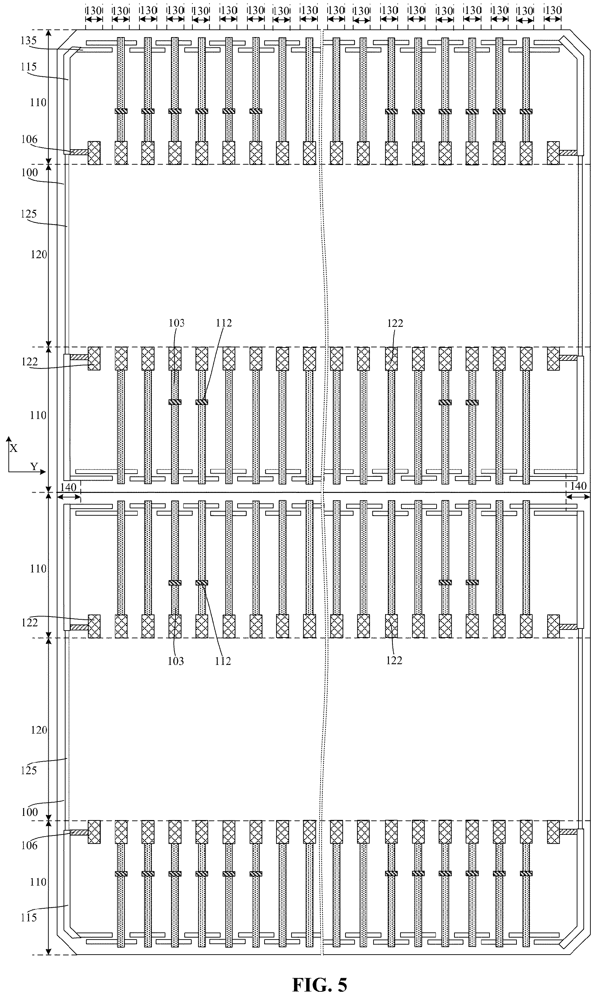

In some embodiments, referring to FIG. 4 or 5, when a single solar cell is a half-cut back contact solar cell, the solar cell includes a chamfered end on a side of one of the two edge regions 110, and a right-angled end on a side of the other edge region 110. A number of first solder joints 112 disposed on the two edge regions 110 with the chamfered end is greater than a number of first solder joints 112 disposed on the two edge regions 110 with the right-angled end.

In some embodiments, referring to FIG. 5, FIG. 5 is a fifth schematic diagram of a partial top view of a solar cell according to some embodiments of the present disclosure. When a single solar cell is a half-cut back contact solar cell, right-angled ends of two adjacent half-cut back contact solar cells along the first direction X are adjacent.

Taking the half-cut back contact solar cell as an example, a correspondence between the solder strips, and the first solder joints 112 and the second solder joints 122 of a plurality of half-cut back contact solar cells are described in detail below.

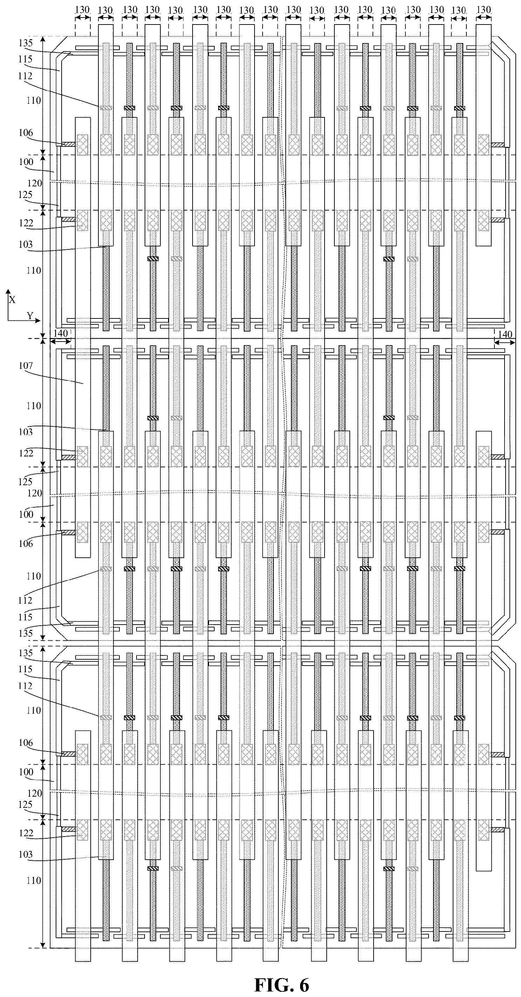

In some embodiments, referring to FIG. 6, FIG. 6 is a sixth schematic diagram of a partial top view of a solar cell according to some embodiments of the present disclosure. For a single half-cut back contact solar cell, a corresponding first solder joint 112 of the first solder joints 112 adjacent to a respective second solder joint 122 of the second solder joints 122 serving as the starting solder joint along the first direction X is not blocked by the solder strips 107. In other words, the solder strips 107 would not extend to the corresponding first solder joint 112 adjacent to the respective second solder joint 122 serving as the starting solder joint. Therefore, after the solder strips 107 are in contact with the half-cut back contact solar cell, the corresponding first solder joints 112 adjacent to the respective second solder joints 122 serving as the starting solder joint is not in contact with the solder strips 107.

In addition, among other first solder joints 112 that are not adjacent to the respective second solder joint 122 serving as the starting solder joint, the solder strips 107 may block the first solder joints 112. In some embodiments, the solder strips 107 are in contact with the first solder joints 112. In some embodiments, the solder strips 107 may not be in contact with the first solder joints 112.

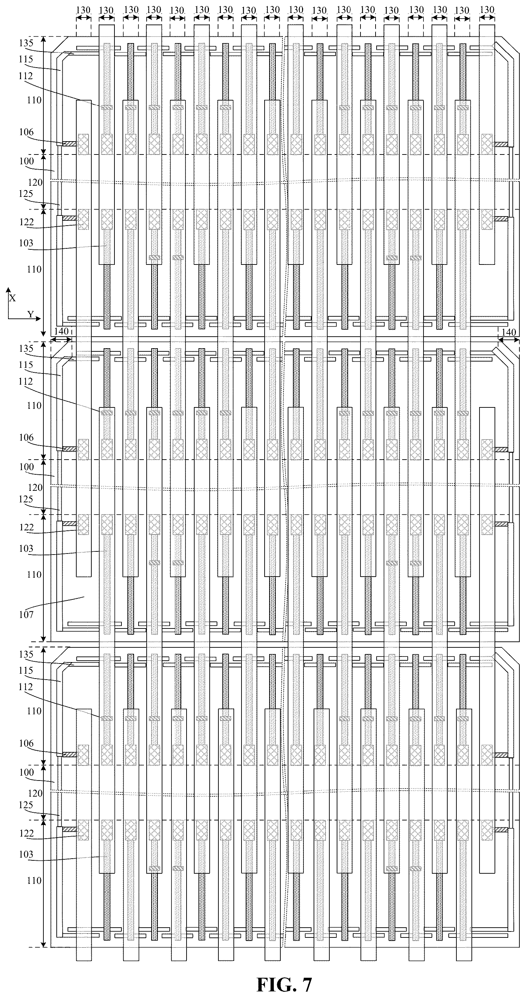

It should be noted that, when a single solar cell is a half-cut back contact solar cell, FIG. 6 only illustrates an example where right-angled ends of two adjacent half-cut back contact solar cells are adjacent along the first direction X, and the corresponding first solder joint 112 adjacent to the respective second solder joint 122 serving as the starting solder joint is not blocked by the solder strips 107. In some embodiments, a single solar cell is a half-cut back contact solar cell. When a right-angled end of one of two adjacent half-cut back contact solar cells is adjacent to a chamfered end of the other of the two adjacent half-cut back contact solar cells along the first direction X, the corresponding first solder joints adjacent to the respective second solder joint serving as the starting solder joint may be blocked by the solder strips, similar to the positional relationship between the solder strips 107 and the corresponding first solder joint 112 shown in FIG. 7.

In some embodiments, referring to FIG. 7, FIG. 7 is a seventh schematic diagram of a partial top view of a solar cell according to some embodiments of the present disclosure. For a single half-cut back contact solar cell, a corresponding first solder joint 112 of the first solder joints 112 adjacent to a respective second solder joint 122 of the second solder joints 122 serving as the starting solder joint along the first direction X is blocked by the solder strips 107. In other words, the solder strip 107 may extend to the corresponding first solder joint 112 adjacent to the respective second solder joint 122 serving as the starting solder joint. Therefore, after the solder strips 107 are in contact with the half-cut back contact solar cell, in some embodiments, the corresponding first solder joint 112 adjacent to the respective second solder joint 122 serving as the starting solder joint are in contact with the solder strips 107. In some embodiments, the f corresponding first solder joint 112 adjacent to the respective second solder joint 122 serving as the starting solder joint may be not in contact with the solder strips 107.

In addition, among other first solder joints 112 that are not adjacent to the respective second solder joints 122 serving as the starting solder joint, the solder strips 107 may block the first solder joints 112. In some embodiments, the solder strips 107 are in contact with the first solder joints 112. In some embodiments, the solder strips 107 may not be in contact with the first solder joints 112. It should be noted that FIGS. 5 to 7 illustrate two sides of the solar cell along the second direction Y using truncated wavy lines, and the truncated wavy lines are drawn with dashed lines. FIG. 6 to 7 illustrate two sides of the solar cell along the first direction X using truncated wavy lines, and the truncated wavy lines are drawn with dashed lines. To clearly illustrate the layout of the corresponding first solder joint 112 and the respective second solder joint 122 on the substrate 100, the grid lines are omitted in FIGS. 5 to 7, the solder strips 107 are illustrated in a perspective view in FIGS. 6 to 7.

It should be noted that, when a single solar cell is a half-cut back contact solar cell, FIG. 6 only illustrates an example where a right-angled end of one of two adjacent half-cut back contact solar cells is adjacent to a chamfered end of the other of the two adjacent half-cut back contact solar cells along the first direction X, and a corresponding first solder joint of the first solder joints adjacent to a respective second solder joint of the second solder joints serving as the starting solder joint along the first direction is blocked by the solder strips . In some embodiments, a single solar cell is a half-cut back contact solar cell. When right-angled ends of two adjacent half-cut back contact solar cells are adjacent along the first direction X, a corresponding first solder joint of the first solder joints adjacent to a respective second solder joint of the second solder joints serving as the starting solder joint along the first direction may not be blocked by the solder strips, similar to the positional relationship between the solder strip 107 and the first solder joints 112 shown in FIG. 6. In some embodiments, referring to FIG. 2 or 3, the solar cell may further include a plurality of columns of third solder joints 132 disposed in the central region 120. A respective third solder joint 132 of the plurality of columns of third solder joints 132 is connected to at least one corresponding grid line 101 of the plurality of grid lines 101, and a respective column of the plurality of columns of third solder joints 132 includes a plurality of third solder joints positioned at intervals along the first direction X and is aligned with two corresponding second solder joints 122 of the second solder joints 122.

In some embodiments, referring to FIG. 3, when the solar cell is a back contact solar cell that do not have a busbar. A respective third solder joint 132 of the plurality of columns of third solder joints 132 may be connected to one corresponding grid line 101 of the plurality of grid lines 101. When the respective third solder joint 132 is connected to a respective first finger electrode 111 of the first finger electrodes 111, the second finger electrodes 121 include a respective second finger electrode 121 disposed between the respective third solder joint 132 and a corresponding third solder joint 132 of the plurality of columns of third solder joints 132 adjacent to the respective third solder joint 132 along the first direction X. Conversely, when the respective third solder joint 132 is in connected to a respective second finger electrode 121 of the second finger electrodes 121, the first finger electrodes 111 include a respective first finger electrode 111 disposed between the respective third solder joint 132 and a corresponding third solder joint 132 adjacent to the respective third solder joint 132 along the first direction X.

In some embodiments, when the solar cell is a solar cell with grid lines on both sides, a single third solder joint may be in contact with either a single grid line or a plurality of grid lines.

Taking a back contact solar cell being the solar cell as an example, the first solder joints 112, the second solder joints 122, and the third solder joint 132 are described in detail below. The refined design of the first solder joints 112, the second solder joints 122, and the third solder joint 132 described below are also applicable to a solar cell with grid lines on both sides.

In some embodiments, referring to FIG. 2 or 3, along a thickness direction of the substrate, a thickness of the respective second solder joint 122 is less than a thickness of the respective first solder joint 112 and a thickness of the respective third solder joint 132. The third direction denotes a thickness direction of the substrate 100.

It is worth noting that, generally, when the subsequent solder strips are in contact with the second solder joints 122 serving as the starting solder joints or the ending solder joints, for example, a relatively greater amount of solder paste is required for soldering, a region of the solder strip directly opposite the respective second solder joints 122 will be raised due to accumulation of solder paste. Accordingly, when the thickness of the respective second solder joint 122 is less than the thickness of the respective first solder joint 112 and the thickness of the respective third solder joint 132, a portion of the solder strips directly opposite the respective second solder joints 122 and a portion of the solder strips directly opposite the respective first solder joints 112 or the respective third solder joint 132 are at the same height, the solder strips are in contact with the first solder joints 112 and the third solder joints 132, and a slight gap may be maintained between the solder strips and the second solder joints 122 to accommodate the solder paste accumulated on the second solder joints 122. This configuration helps effectively avoid the problem where the solder strips directly opposite the second solder joints 122 is raised due to accumulation of solder paste, resulting in poor contact with the first solder joints 112 or the third solder joint 132. This configuration is also conducive to reducing a bending degree of the solder strip. For example, the solder strips can achieve simultaneous electrical connection with the first solder joints 112, the second solder joints 122, and the third solder joint 132 without bending downward. In addition, the second solder joints 122 is configured to have a smaller thickness, preventing the portion of the solder strip directly opposite the second solder joints 122 from being excessively elevated relative to the substrate 100.

In some examples, referring to FIG. 2 or FIG. 3, along the third direction, the thickness of the respective first solder joint 112 may be equal to that of the respective third solder joint 132.

In some embodiments, referring to FIG. 2 or 3, the area of the orthographic projection of the respective first solder joint 112 on the substrate is smaller than or equal to an area of an orthographic projection of a respective third solder joint 132 of the plurality of columns of third solder joints 132 on the substrate 100. This configuration is advantageous for improving the carrier collection capability of the integrated structure formed by the plurality of solder joint connection lines 103 and the first solder joints 112 through the first solder joints 112, and enhancing the connection stability between the solder strips and the integrated structure formed by the plurality of solder joint connection lines 103 and first solder joint 112. It can also minimize the material consumption required for preparing the first solder joints 112, thereby reducing the fabrication cost of the solar cell.

In some embodiments, the area of the orthographic projection of the respective first solder joint 112 on the substrate is smaller than an area of an orthographic projection of a respective third solder joint 132 of the plurality of columns of third solder joints 132 on the substrate 100.

In some examples, a ratio of the area of the orthographic projection of the respective first solder joint 112 on the substrate 100 to that of the respective third solder joint 132 on the substrate 100 may be 0.9. For example, along the second direction Y, a length of the respective first solder joint 112 is equal to a length of the respective third solder joint 132, and along the first direction X, a ratio of a width of the respective first solder joint 112 to a width of the respective third solder joint 132 is 0.9.

In some embodiments, referring to FIG. 2 or 3, the area of the orthographic projection of the respective second solder joint 122 an on the substrate 100 may be greater than that of the respective third solder joint 132 on the substrate 100. This configuration is advantageous for enhancing the alignment accuracy and bonding strength between the subsequent solder strips and the second solder joints 122, while minimizing the material consumption required for preparing the plurality of third solder joints 132, thereby reducing the fabrication cost of the solar cell.

In some embodiments, referring to FIG. 2 or 3, in the first direction X, a distance between the respective second solder joint 122 and a corresponding third solder joint 132 of the plurality of columns of third solder joints 132 adjacent to the respective second solder joint 122 may be smaller than a distance between the respective second solder joint 122 and a corresponding first solder joint 112 of the first solder joints 112 adjacent to the respective second solder joint 122.

In some examples, referring to FIG. 3, the solar cell is a back contact solar cell that do not have busbar. In the first direction X, no grid line 101 may be disposed between the respective second solder joint 122 and a corresponding third solder joint 132 of the plurality of columns of third solder joints 132 adjacent to the respective second solder joint 122, or a grid line 101 having a polarity opposite to that of the grid line 101 connected to the respective third solder joint 132 may be spaced apart between the same. For example, for the respective second solder joint 122 and the corresponding adjacent third solder joint 132 that are both connected with the first finger electrodes 111, no grid line 101 may be disposed between the corresponding second solder joint 122 and the corresponding adjacent third solder joint 132, or the second finger electrodes 121 may be disposed between them. Similarly, for the respective second solder joint 122 and the corresponding adjacent third solder joint 132 that are both connected with the second finger electrodes 121, no grid line 101 may be disposed between the corresponding second solder joint 122 and the corresponding adjacent third solder joint 132, or the first finger electrodes 111 may be disposed between them.

Based on the configuration of the plurality of solder joint connection lines 103 disposed in the two edge regions 110, the plurality of solder joint connection lines 103 may be configured to collect carriers from the plurality of grid lines 101 disposed on sides of the second solder joints 122 away from the central region 120. Therefore, along the first direction X, the first solder joints 112 disposed on the plurality of solder joint connection lines 103 may be spaced from the second solder joints 122 by a plurality of grid lines 101. In this way, when a distance between every two adjacent grid lines 101 is substantially the same, along the first direction X, a distance between the respective second solder joint 122 and the corresponding third solder joint 132 of the plurality of columns of third solder joints 132 adjacent to the respective second solder joint 122 may be smaller than a distance between the respective second solder joint 122 and the corresponding first solder joint 112 of the first solder joints 112 adjacent to the respective second solder joint 122. This configuration ensures that carriers from the plurality of grid lines 101 are efficiently collected. A distance between the rrespective second solder joint 122 and the corresponding first solder joint 112 of the first solder joints 112 adjacent to the respective second solder joint 122 along the first direction X is configured to be greater, when the solder strips are in contact with the second solder joints 122 serving as starting solder joints or ending solder joints, a bending height of the solder strips required per unit length along the first direction X is effectively reduced, that is, a bending degree of the solder strips required per unit length is reduced. Accordingly, it is advantageous for reducing the difficulty of bending the solder strips onto the corresponding first solder joint 112 adjacent to the respective second solder joint 122, further reducing a soldering force exerted by the solder strip on the corresponding first solder joint 112 adjacent to the respective second solder joints 122, thereby effectively preventing the problems of cold solder joints/detached solder joints between the corresponding first solder joint 112 adjacent to the respective second solder joints 122 and the solder strips, and ensuring a stable bonding between the corresponding first solder joint 112 adjacent to the respective second solder joint 122 and the solder strips.

In some embodiments, referring to FIG. 3, the solar cell may be a back contact solar cell. The side of the substrate 100 is divided into alternating first soldering regions 1301 and second soldering regions 1302 disposed along the second direction Y. The plurality of grid lines 101 include alternating first finger electrodes 111 and second finger electrodes 121 disposed along the first direction X. A respective first finger electrode 111 of the first finger electrodes 111 that is disposed in either one of the two edge regions 110 has disconnections in the second soldering regions 1302, and a respective second finger electrode 121 of the second finger electrodes 121 that is disposed in either one of the two edge regions 110 has disconnections in the first soldering regions 1301.

The solar cell may further include a plurality of third solder joints 132 disposed in the central region 120 and positioned at intervals along the first direction X and the second direction Y. A respective third solder joint 132 of the plurality of third solder joints 132 that is disposed in a corresponding first soldering region 1301 of the first soldering regions 1301 is connected to a corresponding first finger electrode 111 of the first finger electrodes 111, and a respective third solder joint 132 of the plurality of third solder joints 132 that is disposed in a corresponding second soldering region 1302 of the second soldering regions 1302 is connected to a corresponding second finger electrode 121 of the second finger electrodes 121.

It is worth noting that, when the solar cell is a back contact solar cell that do not have busbar. Among the first finger electrodes 111 and second finger electrodes 121 disposed in the two edge regions 110, the first finger electrodes 111 are configured to be discontinuous in the second soldering regions 1302, and the second finger electrodes 121 are configured to be discontinuous in the first soldering regions 1301. Among the first finger electrodes 111 and second finger electrodes 121 disposed in the central region 120, the plurality of third solder joints 132 are disposed on a portion of the first finger electrodes 111 disposed in the first soldering region 1301, and the first finger electrodes 111 are not discontinuous in the second soldering regions 1302. Similarly, the plurality of third solder joints 132 are disposed on a portion of the second finger electrodes 121 disposed in the second soldering regions 1302, and the second finger electrodes 121 are not discontinuous in the first soldering regions 1301.

In other words, the first finger electrodes 111 and the second finger electrodes 121 in the two edge regions 110 are segmented along the second direction Y into a plurality of disconnected sections, while the first finger electrodes 111 and the second finger electrodes 121 in the central regions 120 are continuous single segments extending along the second direction Y. When being in contact with the plurality of third solder joints 132, the subsequent solder strips are insulated from the grid lines 101 disposed between every two adjacent third solder joints 132. This configuration allows for a greater portion of the central region 120 to be used for the layout of the first finger electrodes 111 and the second finger electrodes 121, providing additional carrier transport paths within the substrate 100 and thereby improving the carrier collection efficiency of the solar cell.

In some embodiments, referring to FIG. 2, the solar cell may further include auxiliary lines 104. A respective auxiliary line 104 of the auxiliary lines 104 is connected to a corresponding second solder joint 122 of the second solder joints 122, and to at least one corresponding third solder joint 132 of the plurality of third solder joints 132 that is aligned with the corresponding second solder joint in along the first direction X. Accordingly, through the configuration of the respective auxiliary line 104, the corresponding second solder joint 122 is configured to electrically connect to at least one corresponding third solder joint 132 disposed facing the corresponding second solder joints 122 along the first direction X.

It is worth noting that, when the subsequent solder strips are in contact with the second solder joints 122 serving as the starting solder joints or the ending solder joints, for example, a relatively greater amount of solder paste is required for soldering, a region of the solder strips directly opposite the second solder joints 122 will be raised due to accumulation of solder paste. The third solder joints 132 closer to the second solder joints 122 are most affected by the solder paste of the subsequent solder strips. Since the solder strip is difficult to bend over a short distance to be in contact with the third solder joints 132 disposed facing the second solder joints 122, this easily leads to cold solder joints or missed solder joints between the solder strips and the third solder joints 132 facing the second solder joints 122. Furthermore, since the solder strips need to descend sharply within a short distance, detached solder joints are more likely to occur between the solder strip and the third solder joints 132 closer to the second solder joints 122. Accordingly, an auxiliary line 104 is configured to electrically connect the third solder joints 132, which are prone to cold solder joints, missed solder joints or detached solder joints, with the second solder joints 122. Even when the third solder joints 132 closer the second solder joints 122 fails to transmit current to the solder strips due to poor contact between the third solder joints and the solder strips, the third solder joints 132 may still transmit current directly to the second solder joints 122 via the auxiliary line 104, and then to the solder strips. In other words, the arrangement of the auxiliary line 104 ensures that the subsequent solder strips can collect current from the first finger electrodes 111 or the second finger electrodes 121, thereby further improving the photovoltaic conversion efficiency of the solar cell.

In addition, the auxiliary line 104 has a limited extension length along the first direction X, and does not extend over an entire length of the central region 120 along the first direction X. The third solder joints 132 that are not in contact with the auxiliary line 104 are disposed farther away from the second solder joints 122 along the first direction X. Therefore, even when the regions of the solder strips directly opposite the second solder joints 122 are raised due to accumulation of solder paste, the solder strips can easily bend over a longer distance to be in contact with the third solder joints 132 farther away from the second solder joints 122, without exerting excessive soldering force on the third solder joints 132 farther away from the second solder joints 122, effectively preventing cold solder joints/detached solder joints between the third solder joints 132 farther away from the second solder joints 122 and the solder strips, thereby ensuring a stable bonding between the solder strips and the third solder joints 132 farther from the second solder joints 122. Further, after regions of the solder strips directly opposite the second solder joints 122 are raised due to accumulation of solder paste. The solder strips can naturally bend downward over an extended length due to its own gravity, until it is in contact with the third solder joints 132 disposed farther from the second solder joints 122.

In some examples, referring to FIG. 2, the respective auxiliary line 104 may be in contact with one corresponding second solder joint 122 of the second solder joints 122, which is conducive to reducing the material consumption required for fabricating the respective auxiliary line 104, thereby reducing the fabrication cost of the solar cell. In some examples, a plurality of auxiliary lines may be in contact with one corresponding second solder joint 122 of the second solder joints 122, and each of the plurality of auxiliary lines may be in contact with at least one third solder joint disposed facing the second solder joints.

In some examples, referring to FIG. 2, an area of a cross-section of the respective auxiliary line 104 perpendicular to the first direction X is smaller than an area of a cross-section of the respective solder joint connection line103 perpendicular to the first direction X.

It is worth noting that a number of grid lines 101 from which the auxiliary line 104 needs to collect current is less than a number of grid lines 101 from which the plurality of solder joint connection lines 103 needs to collect current. Therefore, a density of current transmitted from the plurality of solder joint connection lines 103 to the second solder joints 122 is greater than a density of current transmitted from the auxiliary line 104 to the second solder joints 122. The area of the cross-section of the respective auxiliary line 104 is designed to smaller than the area of the cross-section of the respective solder joint connection line103, a transmission resistance of the plurality of solder joint connection lines 103 can be further reduced. This facilitates gathering current from more grid lines 101, improving the current collection capability of the plurality of solder joint connection lines 103, and reducing the risk of overheating in the region of the plurality of solder joint connection lines 103 facing the second solder joints 122 where the current density is high. As a result, the electrical performance and yield of the solar cell are improved, and the material consumption required for fabricating the auxiliary line 104 is minimized.

In some examples, referring to FIG. 2, the area of the cross-section of the respective auxiliary line 104 perpendicular to the first direction X is defined as a first area, and the area of the cross-section of a respective grid line 101 of the plurality of grid lines 101 perpendicular to the second direction Y is defined as a second area, where the first area is greater than or equal to the second area.

It is worth noting that the respective auxiliary line 104 not only needs to further transmit the current collected by the plurality of third solder joints 132 from the grid lines 101 to the second solder joints 122, but may also transmit a portion of the current directly from the grid lines 101 to the second solder joints 122. Therefore, compared with the grid lines 101, the respective auxiliary line 104 needs to have a greater current collection capability. Moreover, the respective auxiliary line 104 needs to maintain good electrical contact with both the plurality of third solder joints 132 and the second solder joints 122. Accordingly, the cross-section area of the respective auxiliary line 104 is configured to be larger than the cross-section area of a respective grid line 101 of the grid lines 101, this configuration helps reduce the transmission resistance of the respective auxiliary line 104, and enhance the current collection efficiency. Moreover, this configuration is beneficial for reducing the risk of overheating due to excessive current concentration in the respective auxiliary line 104, and reducing the risk of disconnection between the respective auxiliary line 104 and the third solder joints 132 or the second solder joints 122.

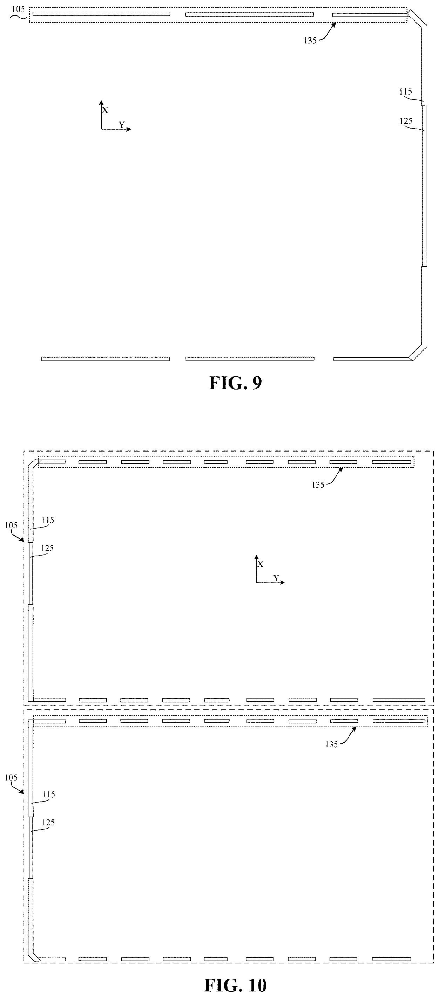

In some embodiments, referring to FIGS. 3 to 9, where FIG. 9 is a schematic diagram of a partial top view of a periphery connection line of a solar cell according to some embodiments of the present disclosure. The solar cell is a back contact solar cell, and the side of the substrate 100 is further divided into two periphery regions 140 opposite to each other. The plurality of grid lines 101 include alternating first finger electrodes 111 and second finger electrodes 121 disposed along the first direction X. The solar cell may further include periphery connection lines 105 at least partially disposed in the two periphery regions 140 and connecting parts 106. A respective periphery connection line 105 of the periphery connection lines 105 is connected to corresponding first finger electrodes 111 of the first finger electrodes 111 or to corresponding second finger electrodes 121 of the second finger electrodes121. A respective connecting part 106 of the connecting parts 106 is configured to connect a corresponding periphery connection line 105 of the periphery connection lines 105 to a corresponding second solder joint 122 of the second solder joints 122 that is closest to a periphery region 140 of the two periphery regions 140 where the corresponding periphery connection line 105 is disposed.

It is worth noting that the respective second solder joint 122, but neither the respective first solder joint nor the respective solder joint connection line, is disposed in the respective soldering region 130 closest the two periphery regions 140. The respective first finger electrodes 111 or the respective second finger electrodes 121 disposed in the respective two edge regions 110 are discontinuous in a respective second closest soldering region 130 from the two periphery regions 140. The respective periphery connection line 105 collects carriers from most of the first finger electrodes 111 or the second finger electrodes 121 in the two edge regions 110, and the carriers are ultimately transported to the second solder joints 122 closest the two periphery regions 140 through the connecting part 106. The remaining first finger electrodes 111 or the second finger electrodes 121 are in direct contact with the second solder joints 122 closest the two periphery regions 140.

In some embodiments, an area of a cross-section of the respective connecting part 106 of the connecting parts 106 perpendicular to the second direction Y is larger than the area of the cross-section of a respective grid line 101 of the grid lines 101, which is conducive to improving the carrier collection efficiency of the connecting part 106 for the plurality of first finger electrodes 111 or the plurality of second finger electrodes 121.

In some embodiments, referring to FIGS. 3 to 10, the respective periphery connection line 105 includes widened portions 115 respectively disposed in the two edge regions 110 and a main body portion 125 disposed in the central region 120, each of the widened portions 115 and the main body portion 125 extends along the first direction X, a respective widened portion 115 of the widened portions 115 has a first end connected to the main body portion 125 and to a corresponding connecting part 106 of the connecting parts 106, and in a second direction Y, a width of the respective widened portion 115 is greater than a width of the main body portion 125.

It is worth noting that the first finger electrodes 111 or the second finger electrodes 121 that are in contact with the main body portion 125 is provided with the plurality of third solder joints 132. The subsequent solder strips, by being in contact with the plurality of third solder joints 132, can collect carriers from the grid lines 101. The first finger electrodes 111 or the second finger electrodes 121 that are in contact with the widened portion 115 is not provided with the plurality of third solder joints 132. Instead, the widened portion 115 needs to collect carriers from the plurality of first finger electrodes 111 or the plurality of second finger electrodes 121, a width of the widened portion 115 is thus configured to be greater than a width of the main body portion 125, which helps improve the carrier collection capability of the widened portion 115, enabling it to match more grid lines 101.

In some examples, referring to FIGS. 3 to 10, the respective periphery connection line 105 further includes edge portions 135 respectively disposed in the two edge regions 110 and extending along the second direction Y, a respective edge portion 135 of the edge portions 135 has an end connected to a second end of the respective widened portion 115, the respective edge portion 135 is connected to first solder joint connection lines 103of the plurality of solder joint connection lines 103 that are connected to corresponding first finger electrodes 111 of the first finger electrodes 111 and has disconnections at second solder joint connection lines 103 of the plurality of solder joint connection lines 103 that are connected to corresponding second finger electrodes 121 of the second finger electrodes 121, or the respective edge portion 135 is connected to the second solder joint connection lines 103 and has disconnections at the first solder joint connection lines 103.

In some examples, the edge portion 135 of the periphery connection line 105 may be fabricated together with the grid lines 101. In other words, each of the edge portion 135 and the grid lines 101 may be embedded in a passivation layer of the substrate 100 and in contact with a doped layer within the substrate 100, thereby directly collecting carriers from the substrate 100 to form a denser current collection network. In addition, both the widened portion 115 and the main body portion 125 may be disposed on a surface of the passivation layer of the substrate 100.

In some embodiments, referring to FIGS. 6 and 10, when a single solar cell is a half-cut back contact solar cell, and right-angled ends of two adjacent half-cut back contact solar cells are adjacent along the first direction X, two periphery connection lines 105 belonging respectively to the two adjacent half-cut back contact solar cells are disposed as shown in FIG. 10, where the widened portions 115 of the two periphery connection lines 105 that do not have corner turns are adjacent to each other along the first direction X.

In some embodiments, referring to FIG. 7, when a single solar cell is a half-cut back contact solar cell, and a right-angled end of one of the half-cut back contact solar cell is adjacent to a chamfered end of the half-cut back contact solar cell along the first direction X, the two periphery connection lines 105 belonging respectively to the two adjacent half-cut back contact solar cells are disposed as shown in FIG. 10, where the widened portion 115 of one of the two periphery connection lines 105 that does not have a corner is adjacent to the widened portion 115 that has a corner of the other of the two periphery connection lines 105 along the first direction X.

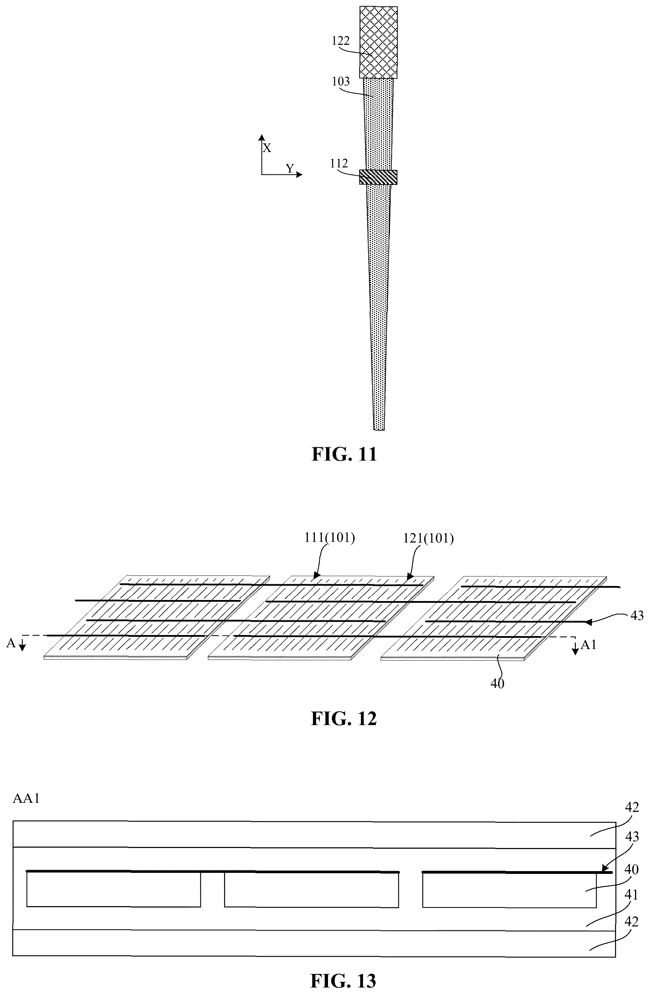

In some embodiments, referring to FIG. 11, which is a top view of a combination of a solder joint connection line 103, a first solder joint 112 and a second solder joint 122 according to some embodiments of the present disclosure, along the second direction Y, a width of a third end portion of a respective solder joint connection line 103 of the plurality of solder joint connection lines 103 disposed facing a respective second solder joint 122 of the second solder joints 122 is greater than a width of a fourth end portion disposed farther away from the respective second solder joint 122.

On the one hand, when the subsequent solder strips are in contact with the second solder joints 122 serving as the starting solder joints or the ending solder joints, for example, a relatively greater amount of solder paste is required for soldering, a region close to the second solder joints 122 is more likely to come into contact with the molten solder paste. Therefore, in the plurality of solder joint connection lines 103, the third end portion closer to the second solder joints 122 is more likely to experience fracture issues due to exposure to the molten solder paste then the fourth end portion disposed farther away from the second solder joints 122. For example, the third end portion may break after cooling due to thermal expansion and contraction during cooling of the molten solder paste. Accordingly, along the second direction Y, the third end portion close to the second solder joints 122 is configured to a greater width than that of the fourth end portion disposed farther away from the second solder joints 122, which is advantageous for reducing the risk of cracking in the third end portion caused by the molten solder paste due to a greater width of the third end portion, thereby enhancing the structural stability of the plurality of solder joint connection lines 103.

On the other hand, the two edge regions110 (see FIG. 3) is more susceptible to greater external force than the central region 120 (see FIG. 3). Accordingly, along the second direction Y, the width of the third end portion is configured to be greater than that of the fourth end portion, which helps increase a contact area between the third end portion and the second solder joints 122, thereby enhancing a bonding strength between the third end portion and the second solder joints 122, and reducing the risk of detachment of the third end portion from the second solder joints 122 due to greater external force.

Moreover, since the plurality of solder joint connection lines 103 is capable of collecting carriers from the plurality of grid lines 101 (see FIG. 3) that are disposed in the two edge regions 110 and that are not in contact with the second solder joints 122, a number of grid lines 101 in contact with the plurality of solder joint connection lines 103 gradually increases from the two edge regions 110 toward the central region 120. Accordingly, carriers collected in the plurality of solder joint connection lines 103 gradually increase. The width of the third end portion is configured to be greater, which helps reduce a transmission resistance of the third end portion and increase a contact area between the third end portion and the second solder joints 122, thereby reducing the transmission resistance of carriers along a path from the plurality of solder joint connection lines 103 and/or the first solder joints 112 to the second solder joints 122 through various ways. This further enhances the carrier collection capability of the integrated structure formed by the plurality of solder joint connection lines 103 and the first solder joints 112 to match more grid lines 101, and also reduces the risk of overheating at the third end portion of the plurality of solder joint connection lines 103 caused by accumulation of carriers, thereby improving the electrical performance and yield of the solar cell.

In addition, the plurality of solder joint connection lines 103 are configured to have varying widths along the second direction Y at different portions along the first direction X, which is conducive to reasonably reducing the material consumption required for fabricating the plurality of solder joint connection lines 103, thereby reducing the fabrication cost of the solar cell.

In some embodiments, still referring to FIG. 11, the respective solder joint connection line 103 tapers along a direction directing from the central region 120 (see FIG. 3) to a corresponding edge region 110 of the two edge regions 110 (see FIG. 3). In this way, along the directiondirecting from the corresponding edge regions 110 to the central region 120, at least one solder joint connection line 103 along the second direction Y tapers, causing the transmission resistance of a respective solder joint connection line 103 of the plurality of solder joint connection lines 103 to decrease gradually. This facilitates gathering carriers from more grid lines 101, improving the carrier collection capability of the respective solder joint connection lines 103, and reducing the risk of overheating in the region of the plurality of solder joint connection lines 103 close to the second solder joints 122 where excessive carriers are gathered. As a result, the electrical performance and yield of the solar cell are improved.

It is worth noting that a single solar cell may be configured to include a plurality of solder joint connection lines 103. The variation in width of any of the plurality of solder joint connection lines 103 along the second direction Y at different portions of the first direction X may be adjusted as needed. Along the second direction Y, a width of the third end portion of any of the plurality of solder joint connection lines 103 is configured to be greater than a width of the fourth end portion, which can enhance the structural stability of the plurality of solder joint connection lines 103, improve the carrier collection capability of the plurality of solder joint connection lines 103, and increase a bonding strength between the third end portion and the second solder joints 122, thereby reducing the risk of detachment between the third end portion and the second solder joints 122.

In some embodiments, referring to FIGS. 1 to 3, a number of grid lines 101 in contact with a single solder joint connection line 103 may be greater than a number of grid lines 101 in contact with a single second solder joint 122. Accordingly, when a distance between every two adjacent grid lines 101 of the grid lines 101 along the first direction X is substantially the same, the second solder joints 122 is caused to be disposed in a region of the two edge regions 110 facing the central region 120, thereby preventing the second solder joints 122 from being too close to an outer periphery of the substrate 100. This helps avoid breakage of a peripheral portion of the substrate 100 during the subsequent soldering process when the solder strip is in contact with the second solder joints 122.

In summary, on the one hand, the solder joint in the two edge regions 110 and closest to the outer side of the substrate 100 is configured to be the respective first solder joint 112 with a smaller area of an orthographic projection, rather than the respective second solder joint 122 with a larger area of an orthographic projection. Compared with disposing the first solder joints 112 in the two edge regions 110 closer the central region 120, this configuration is advantageous for disposing the second solder joints 122 in the two edge regions 110 closer the central region 120, thereby reducing the risk of the second solder joints 122 being subjected to relatively large external force, and reducing a magnitude of external force acting on the second solder joints 122. This helps lower the probability of cold solder joints or missed solder joints during subsequent soldering of the solder strips to the second solder joints 122 as well as the probability of detached solder joints after the subsequent soldering of the solder strips to the second solder joints 122. On the other hand, as the starting solder joint or the ending solder joint for the subsequent solder strip, the second solder joints 122 is configured to have a larger area of an orthographic projection on the substrate 100, which not only reduces a transfer resistance of the second solder joints 122 itself, thereby improving the carrier collection efficiency of the second solder joints 122, but also enhances alignment accuracy and bonding strength between the solder strips and the second solder joints 122. In addition, this configuration prevents problems such as cold solder joints or detached solder joints caused by excessive force exerted by the solder strips on the respective second solder joint 122 (which serves as the starting solder joint or the ending solder joint), further contributes to improving the carrier collection efficiency of the second solder joints 122 and the bonding reliability between the solder strips and the second solder joints 122.

In addition, the plurality of solder joint connection lines 103 are configured to be in contact with the first solder joints 112 and the second solder joints 122, as well as is in contact with a plurality of grid lines 101 disposed on sides of the plurality of second solder joint 122 away from the central region 120. In this way, the plurality of solder joint connection lines 103 cannot only be in electrical connection with the first solder joints 112 and the second solder joints 122, but also collect carriers from the plurality of grid lines 101 on the sides of the second solder joints 122 away from the central region 120, ultimately transporting the carriers to the first solder joints 112 and/or the second solder joints 122. Moreover, on the one hand, based on the configuration of the first solder joints 112, it is advantageous for disposing the second solder joints 122 in the two edge regions 110 closer the central region 120. Accordingly, the plurality of grid lines 101 disposed on the sides of the second solder joints 122 away from the central region 120 become increased. Therefore, the plurality of solder joint connection lines 103 are in contact with the first solder joints 112 to form integrally, thereby serving as a bus portion. In this way, a volume of the bus portion can be increased, thereby reducing a transmission resistance of the bus portion, thereby enabling the bus portion to match a greater number of grid lines 101, efficiently collecting carriers from the greater number of grid lines 101, and improving the transport efficiency of carriers in the solar cell. On the other hand, the first solder joints 112 being disposed on the plurality of solder joint connection lines 103 is beneficial for increasing an area of an orthographic projection of an integrated structure (that is, the bus portion) formed by the plurality of solder joint connection lines 103 and the first solder joints 112 on the substrate 100, thereby increasing a contact area between the subsequent solder strips and the bus portion, and improving the transport efficiency of carriers in the solar cell.

Some embodiments of the present disclosure provide a photovoltaic module, which is formed by connecting a plurality of solar cells. Each solar cell of the plurality of solar cells is provided in the foregoing embodiments. The photovoltaic module according to some embodiments of the present disclosure will be further described in detail below in conjunction with the accompanying drawings. It should be noted that description identical or corresponding to the previous embodiments are not repeated in detail herein.

Referring to FIGS. 12 and 13, as well as FIGS. 1 to 11, the photovoltaic module includes: at least one cell string formed by connecting a plurality of solar cells, where each solar cell of the plurality of solar cell being provided in the foregoing embodiments; at least one encapsulating film 41 configured to cover at least one surface of the at least one cell string; and at least one cover plate 42 configured to cover at least one surface of the at least one encapsulating film 41 away from the at least one cell string.

FIG. 12 is a schematic diagram of a partial perspective view of a photovoltaic module according to some embodiments of the present disclosure, and FIG. 13 is a schematic diagram of a partial sectional view of the photovoltaic module in FIG. 12 along a first cross-sectional direction AA1.

In some embodiments, a plurality of solar cells 40 are electrically connected as a whole sheet or in a plurality of sheets to form a plurality of cell strings, and the plurality of cell strings are electrically connected in series and/or in parallel. A respective solar cell 40 of the plurality of solar cells 40 may be either a full-size solar cell or a sliced solar cell, where the sliced solar cell refers to a solar cell formed from a complete full-size solar cell through a cutting process.

In some embodiments, referring to FIG. 12 or FIG. 13, the plurality of solar cells 40 may be electrically connected to each other by conductive strips 43. FIGS. 12 and 13 illustrate only a positional relationship between the plurality of solar cells 40. In some embodiments, grid lines of adjacent solar cells of the plurality of solar cells may also be disposed on different sides of the plurality of solar cells, thus the conductive strips are capable of electrically connecting different sides of every two adjacent solar cells of the plurality of solar cells.

In some embodiments, the at least one encapsulating film 41 includes a first encapsulating layer and a second encapsulating layer, where the first encapsulating layer covers one of a front side or a back side of a respective solar cell 40 of the plurality of solar cells 40, and the second encapsulating layer covers the other of the front side or the back side of the respective solar cell 40. At least one of the first encapsulating layer or the second encapsulating layer may be an organic encapsulating film, such as a polyvinyl butyral (PVB) film, an ethylene-vinyl acetate (EVA) film, a polyolefin elastomer (POE) film, or a polyethylene terephthalate (PET) film. In some embodiments, at least one of the first encapsulating layer and the second encapsulating layer may be such as an EP film, an EPE film, or a PVP film. The EP film is a coextruded film formed by stacking EVA films and POE films, The EPE film is a coextruded film formed by sequentially stacking EVA film, POE film, and EVA film. The PVP film is a coextruded film formed by stacking POE film, EVA film, and POE film. The coextruded film may be prepared by sequentially extruding one or more raw materials onto another already manufactured film during a film processing process, or by bonding different types of already manufactured films together.

In some embodiments, the first encapsulating layer and the second encapsulating layer have boundary lines before lamination. After the lamination process, the photovoltaic module is formed and the first encapsulating layer and the second encapsulating layer no long have boundary lines. That is, the first encapsulating layer and the second encapsulating layer have formed an integral encapsulating film 41.

In some embodiments, the at least one cover plate 42 such as glass cover plate, plastic cover plate, or the like, may have a light-transmitting function. In some embodiments, at least one surface of the at least one cover plate 42 facing the at least one encapsulating film 41 may be a concave-convex surface or a textured surface with multiple protrusion structures, thereby increasing a utilization rate of incident light. The at least one cover plate 42 includes a first cover plate opposite to the first encapsulating layer, and a second cover plate opposite to the second encapsulating layer.

In some embodiments, the respective solar cell 40 is a back contact solar cell without busbars. The back contact solar cell without busbars has a plurality of grid lines 101 spaced form each other along a first direction X on a surface of the back contact solar cell. In the process of fabricating the at least one cell string using a plurality of back contact solar cells without busbars, the conductive strip 43 are electrically connected to a plurality of grid lines 101 on each respective back contact solar cell without busbars of every two adjacent back contact solar cells without busbars of the plurality of back contact solar cells without busbars.

It may be understood by those skilled in the art that the above embodiments are particular embodiments to implement the present disclosure, and in a practical application, various changes can be made to the form and details without departing from the scope of the embodiments of the present disclosure. Those skilled in the art may make variations or modifications without departing from the scope of the embodiments of the present disclosure, therefore, the scope of protection of the embodiments of the present disclosure shall be subject to the scope of protection as defined by the claims.

## Claims

1. A solar cell, **characterized by** comprising:
a substrate (100), a side of the substrate (100) being divided into two edge regions (110) opposite to each other and a central region (120) formed between the two edge regions (110);
a plurality of grid lines (101) disposed on the substrate (100) and positioned at intervals along a first direction (X);
first solder joints (112) and second solder joints (122) disposed in the two edge regions (110), wherein the first solder joints (112) are positioned at intervals along a second direction (Y) perpendicular to the first direction (X) the second solder joints (122) are positioned at intervals along the second direction (Y) and closer to the central region (120) than the first solder joints (112), and an area of an orthographic projection of a respective first solder joint (112) of the first solder joints (112) on the substrate (100) is smaller than an area of an orthographic projection of a respective second solder joint (122) of the second solder joints (122) on the substrate (100); and
a plurality of solder joint connection lines (103) disposed in the two edge regions (110), wherein a respective solder joint connection line (103) of the plurality of solder joint connection lines (103) is connected to a corresponding first solder joint (112) of the first solder joints (112), to a corresponding second solder joint (122) of the second solder joints (122), and to grid lines (101) of the plurality of grid lines (101) disposed on a side of the corresponding second solder joint (122) away from the central region (120).

2. The solar cell according to claim 1, wherein a number of grid lines (101) of the plurality of grid lines (101) in contact with a respective first solder joint (112) of the first solder joints (112) is less than or equal to a number of grid lines (101) of the plurality of grid lines (101) in contact with a respective second solder joint (122) of the second solder joints (122); and/or
wherein the side of the substrate (100) is further divided into a plurality of soldering regions (130) positioned at intervals along the second direction (Y) and overlapped the two edge regions (110), and two corresponding second solder joints (122) of the second solder joints (122), at least one corresponding first solder joint (112) of the first solder joints (112), and at least one corresponding solder joint connection line (103) of the plurality of solder joint connection lines (103) are disposed in a respective soldering region (130) of the plurality of soldering regions (130).

3. The solar cell according to claim 1 or claim 2, wherein the solar cell is a back contact solar cell, the side of the substrate (100) is divided into a plurality of soldering regions (130) positioned at intervals along the second direction (Y) and overlapped the two edge regions (110), the first solder joints (112) are disposed alternately on both sides of the central region (120), and a respective first solder joint (112) of the first solder joints (112) is disposed in a corresponding soldering region (130) of the plurality of soldering regions (130).

4. The solar cell according to claim 1 or claim 2, wherein the side of the substrate (100) is divided into a plurality of soldering regions (130) positioned at intervals along the second direction (Y) and overlapped the two edge regions (110), a respective first solder joint (112) of the first solder joints (112) is disposed in a corresponding soldering region (130) of the plurality of soldering regions (130), and a number of first solder joints (112) disposed on a first side of the central region (120) is greater than a number of first solder joints (112) disposed on an opposing second side of the central region (120).

5. The solar cell according to claim 4, wherein one respective soldering region (130) of the plurality of soldering regions (130) has a first solder joint (112) disposed on the second side and in the respective soldering region (130) further has a first solder joint (112) disposed on the first side and in the respective soldering region (130).

6. The solar cell according to claim 4, wherein both a number of the first solder joints (112) disposed on the second side and a number of the plurality of soldering regions (130) are even numbers, and either the plurality of soldering regions (130) or the first solder joints (112) disposed on the second side are in axially symmetric arrangement about a central axis along the first direction (X).

7. The solar cell according to any one of claims 1 to 6, further including a plurality of columns of third solder joints (132) disposed in the central region (120), wherein a respective third solder joint (132) of the plurality of columns of third solder joints (132) is connected to at least one corresponding grid line (101) of the plurality of grid lines (101), and a respective column of the plurality of columns of third solder joints (132) includes a plurality of third solder joints (132) positioned at intervals along the first direction (X) and is aligned with two corresponding second solder joints (122) of the second solder joints (122); and
wherein along a thickness direction of the substrate (100), a thickness of the respective second solder joint (122) is less than a thickness of the respective first solder joint (112) and a thickness of the respective third solder joint (132), and/or the area of the orthographic projection of the respective first solder joint (112) on the substrate (100) is smaller than or equal to an area of an orthographic projection of a respective third solder joint (132) of the plurality of columns of third solder joints (132) on the substrate (100).

8. The solar cell according to claim 7, wherein in the first direction (X), a distance between the respective second solder joint (122) and a corresponding third solder joint (132) of the plurality of columns of third solder joints (132) adjacent to the respective second solder joint (122) is smaller than a distance between the respective second solder joint (122) and a corresponding first solder joint (112) of the first solder joints (112) adjacent to the respective second solder joint (122).

9. The solar cell according to any one of claims 1 to 6, wherein the solar cell is a back contact solar cell, the side of the substrate (100) is further divided into alternating first soldering regions (1301) and second soldering regions (1302) disposed along the second direction (Y), the plurality of grid lines (101) include alternating first finger electrodes (111) and second finger electrodes (121) disposed along the first direction (X), a respective first finger electrode (111) of the first finger electrodes (111) that is disposed in either one of the two edge regions (110) has disconnections in the second soldering regions (1302), and a respective second finger electrode (121) of the second finger electrodes (121) that is disposed in either one of the two edge regions (110) has disconnections in the first soldering region (1301); and
wherein the solar cell further includes a plurality of third solder joints (132) disposed in the central region (120) and positioned at intervals along the first direction (X) and the second direction (Y), a respective third solder joint (132) of the plurality of third solder joints (132) that is disposed in a corresponding first soldering region (1301) of the first soldering regions (1301) is connected to a corresponding first finger electrode (111) of the first finger electrodes (111), and a respective third solder joint (132) of the plurality of third solder joints (132) that is disposed in a corresponding second soldering region (1302) of the second soldering regions (1302) is connected to a corresponding second finger electrode (121) of the second finger electrodes (121).

10. The solar cell according to claim 9, further including auxiliary lines (104), wherein a respective auxiliary line (104) of the auxiliary lines (104) is connected to a corresponding second solder joint (122) of the second solder joints (122), and to at least one corresponding third solder joint (132) of the plurality of third solder joints (132) that is aligned with the corresponding second solder joint (122) in the first direction (X); and
wherein an area of a cross-section of the respective auxiliary line (104) perpendicular to the first direction (X) is smaller than an area of a cross-section of the respective solder joint connection line (103) perpendicular to the first direction (X).

11. The solar cell according to claim 1, wherein the solar cell is a back contact solar cell, the side of the substrate (100) is further divided into two periphery regions (140) opposite to each other, each periphery region (140) of the two periphery regions (140) extends along the first direction (X), and the plurality of grid lines (101) include alternating first finger electrodes (111) and second finger electrodes (121) disposed along the first direction (X); and
wherein the solar cell further includes:
periphery connection lines (105) at least partially disposed in the two periphery regions (140), wherein a respective periphery connection line (105) of the periphery connection lines (105) is connected to corresponding first finger electrodes (111) of the first finger electrodes (111) or to corresponding second finger electrodes (121) of the second finger electrodes (121), and
connecting parts (106), wherein a respective connecting part (106) of the connecting parts (106) is configured to connect a corresponding periphery connection line (105) of the periphery connection lines (105) to a corresponding second solder joint (122) of the second solder joints (122) that is closest to a periphery region (140) of the two periphery regions (140) where the corresponding periphery connection line (105) is disposed.

12. The solar cell according to claim 11, wherein the respective periphery connection line (105) includes widened portions (115) respectively disposed in the two edge regions (110) and a main body portion (125) disposed in the central region (120), each of the widened portions (115) and the main body portion (125) extends along the first direction (X), a respective widened portion (115) of the widened portions (115) has a first end connected to the main body portion (125) and to a corresponding connecting part (106) of the connecting parts (106), and in the second direction (Y), a width of the respective widened portion (115) is greater than a width of the main body portion (125).

13. The solar cell according to claim 12, wherein the respective periphery connection line (105) further includes edge portions (135) respectively disposed in the two edge regions (110) and extending along the second direction (Y), a respective edge portion (135) of the edge portions (135) has an end connected to a second end of the respective widened portion (115), the respective edge portion (135) is connected to first solder joint connection lines of the plurality of solder joint connection lines (103) that are connected to corresponding first finger electrodes (111) of the first finger electrodes (111) and has disconnections at second solder joint connection lines of the plurality of solder joint connection lines (103) that are connected to corresponding second finger electrodes (121) of the second finger electrodes (121), or the respective edge portion (135) is connected to the second solder joint connection lines and has disconnections at the first solder joint connection lines.

14. The solar cell according to claim 1, wherein the respective solder joint connection line (103) tapers along a direction directing from the central region (120) to a corresponding edge region (110) of the two edge regions (110) where the respective solder joint connection line (103) is disposed.

15. A photovoltaic module, including:
at least one cell string formed by connecting a plurality of the solar cells, wherein each solar cell of the plurality of the solar cells is the solar cell according to any one of claims 1 to 14;
at least one encapsulating film (41) configured to cover at least one surface of the at least one cell string; and
at least one cover plate (42) configured to cover at least one surface of the at least one encapsulating film (41) away from the at least one cell string.
